# FASCICULE DE BREVET EUROPEEN

(11) **EP 4 552 161 B1**
(45) Date de publication et mention de la délivrance du brevet: **02.12.2026**
(21) Numéro de dépôt: 23751332.0
(22) Date de dépôt: 04.07.2023
(51) Int. Cl.: H10F 19/80, B32B 17/10

(54) **PROCÉDÉ DE FABRICATION D'UN MODULE PHOTOVOLTAÏQUE UTILISANT UN MOULAGE PAR TRANSFERT DE RÉSINE**
VERFAHREN ZUR HERSTELLUNG EINES PHOTOVOLTAIKMODULS MITTELS HARZTRANSFERGIESSEN
METHOD FOR PRODUCING A PHOTOVOLTAIC MODULE BY MEANS OF RESIN TRANSFER MOULDING

(30) Priorité: 04.07.2022 FR 2206779
(43) Date de publication de la demande: 14.05.2025
(73) Titulaire: Commissariat à l'Energie Atomique et aux Energies Alternatives, 75015 Paris (FR); Centre technique industriel de la plasturgie et des composites, 92300 Levallois-Perret (FR); Université Savoie Mont Blanc, 73000 Chambéry (FR)
(72) Inventeur: DUIGOU, Tatiana, 38054 Grenoble cedex 09 (FR); GAUME, Julien, 38054 Grenoble cedex 09 (FR); TENCHINE, Lionel, 01100 Oyonnax (FR); BOICHON, Vincent, 53000 Laval (FR)
(74) Mandataire: Germain Maureau
(86) Numéro de dépôt international: PCT/FR2023/051022
(87) Numéro de publication internationale: WO 2024/009035

(56) Documents cités:
- EP-A1- 2 388 830
- WO-A1-2013/119113
- US-A1- 2021 249 549

## Description

### Domaine technique de l'invention

La présente invention se rapporte au domaine de la fabrication des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin, et en particulier un module photovoltaïque sans plaque de verre, léger et rigide, avec possibilité d'être conformé selon une forme gauche.

Plus précisément, l'invention concerne un procédé de fabrication d'un module photovoltaïque.

L'invention peut être mise en oeuvre pour de nombreuses applications, notamment civiles et/ou militaires, par exemple des applications autonomes et/ou embarquées, étant particulièrement concernées par les applications qui requièrent l'utilisation de modules photovoltaïques sans plaque de verre et légers, en particulier de forme non plane, et de faible épaisseur, notamment inférieure à 5 mm. Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, des drones, des ballons dirigeables, entre autres.

Dans le reste du document, une forme dite gauche est une forme non plane, courbe, incurvée, bombée ou creuse, et plus généralement présentant une forme générale en trois dimensions non orientée suivant un plan principal.

### Etat de la technique

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par au moins une couche à base de polymères fluorés, comme le polyfluorure de vinyle (PVF) ou le polyfluorure de vinylidène (PVDF), et ayant une épaisseur totale de l'ordre de 300-400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type connu sous l'acronyme IBC.

Il est à noter que les cellules photovoltaïques de type IBC sont des structures pour lesquelles les contacts sont réalisés sur la face arrière de la cellule en forme de peignes dont les doigts sont interconnectés. Elles sont par exemple décrites dans le document US4478879A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

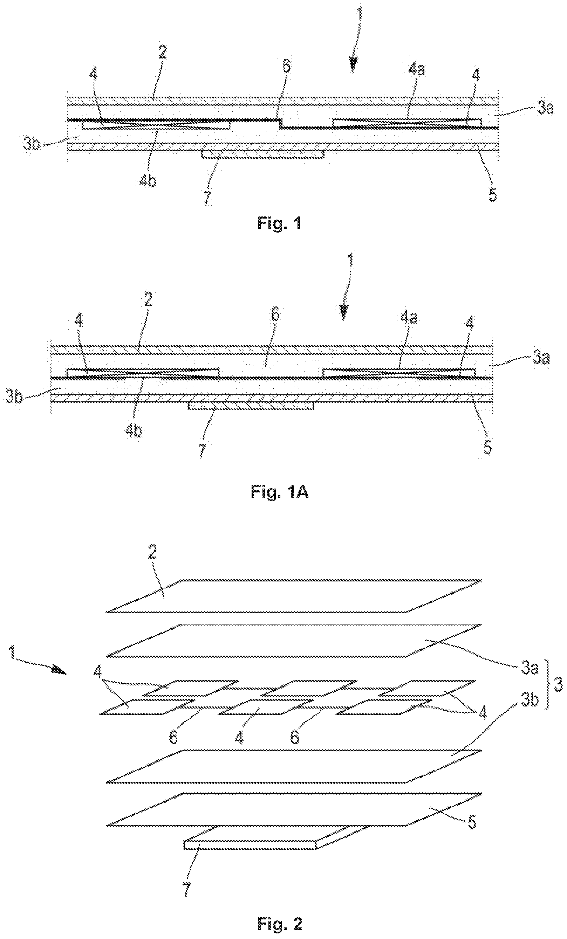

Il est ainsi représenté partiellement et schématiquement, respectivement en coupe sur la figure 1 et en vue éclatée sur la figure 2, un exemple connu de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

La figure 1A représente en outre une variante de réalisation de l'exemple de la figure 1 dans laquelle les cellules photovoltaïques 4 sont de type IBC, les conducteurs de liaison 6 étant uniquement disposés contre les faces arrière des cellules photovoltaïques 4.

Par ailleurs, les figures 1 et 2 représentent également la boîte de jonction 7 du module photovoltaïque 1, destinée à recevoir le câblage nécessaire à l'exploitation du module photovoltaïque 1. Classiquement, cette boîte de jonction 7 est réalisée en plastique ou en caoutchouc, et présente une étanchéité complète.

De façon habituelle, la fabrication du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 165°C, et pendant une durée du cycle de lamination d'au moins 10 minutes, voire 15 minutes.

Pendant cette étape de lamination, les couches de matériau d'encapsulation 3a et 3b subissent une fusion et viennent englober les cellules photovoltaïques 4, en même temps que l'adhérence se crée à toutes les interfaces entre les couches, à savoir :
- entre la face avant 2 et la couche avant de matériau d'encapsulation 3a,
- entre la couche avant de matériau d'encapsulation 3a et les faces avant 4a des cellules photovoltaïques 4,
- entre les faces arrière 4b des cellules photovoltaïques 4 et la couche arrière de matériau d'encapsulation 3b,
- entre la couche arrière de matériau d'encapsulation 3b et la face arrière 5 du module photovoltaïque 1.

C'est l'adhérence entre ces différents composants qui permet de réaliser l'assemblage du module photovoltaïque 1 étant un produit qui est alors d'un seul tenant qui est ensuite encadré, typiquement grâce à un cadre utilisant des profilés en aluminium.

Une telle structure est maintenant devenue un standard qui possède une résistance mécanique importante grâce à l'utilisation d'une face avant 2 en verre épais et du cadre en aluminium, lui permettant, notamment et dans la majorité des cas, de respecter les normes IEC 61215 et IEC 61730.

Néanmoins, un tel module photovoltaïque 1 présente l'inconvénient essentiel d'avoir une masse élevée, en particulier une masse par unité de surface (ou masse surfacique) d'environ 10 à 12 kg/m², ce qui le rend inadapté pour les applications pour lesquelles la légèreté est une priorité.

Cette masse élevée du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre en aluminium. Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 2 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % de la masse du module photovoltaïque 1, et plus de 80 % en incluant le cadre en aluminium.

Aussi, afin d'obtenir une réduction significative de la masse d'un module photovoltaïque pour permettre son utilisation dans de nouvelles applications exigeantes en termes de légèreté et de mise en forme, il a déjà été essayé de trouver une solution alternative à l'utilisation d'un verre épais en face avant du module photovoltaïque, par l'utilisation de nouveaux matériaux plastiques ou composites avec pour but principal d'obtenir une diminution importante de la masse surfacique.

Ainsi, des feuilles en matière thermoplastique non renforcées de type polymères comme le polycarbonate (PC), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative par rapport au verre. Cependant, lorsque seul le remplacement du verre par une telle feuille mince de polymères est envisagé, la cellule photovoltaïque devient très vulnérable au choc, à la charge mécanique et aux dilatations différentielles.

Une autre alternative est l'utilisation, au moins en face avant, de matériaux composites à base d'au moins un renfort et d'une résine thermodurcissable, en remplacement du verre standard. Le gain de masse peut être significativement important au prix d'une moins bonne transparence.

Pour répondre aux enjeux de gain de poids, les procédés majoritairement utilisés exploitent les principes d'une lamination à chaud sous vide, ou plus rarement les principes de l'infusion.

Dans la technique de lamination, les première et deuxième couches formant les faces avant et arrière du module photovoltaïque sont au moins partiellement fabriquées en même temps que l'ensemble encapsulant n'est formé et une bâche est présente pour appliquer une pression homogène durant une mise en pression de l'empilement. La mise en œuvre de telles techniques pour des formes gauches présenterait de grandes difficultés car l'application d'une pression homogène par la bâche sur un empilement d'épaisseur non homogène, du fait d'un phénomène de fluage du matériau d'encapsulation vers des points bas du moule résultant des conditions de chauffe, induirait l'obtention inévitable d'un module photovoltaïque ayant une épaisseur non homogène.

Le moulage par infusion sous vide, ou plus simplement l'infusion, est une technique traditionnelle de mise en œuvre des matériaux composites. Elle consiste à la mise sous vide, dans un moule fermé par une bâche, des renforts secs qui sont imprégnés par la suite avec l'arrivée de résine qui est aspirée par la dépression créée entre la bâche et le moule. Ce type de procédé est malheureusement non industrialisable en raison de sa faible cadence et du fait qu'il n'est pas automatisable.

Dans les procédés de fabrication connus, on peut ainsi par exemple citer les documents de brevets suivants :
- WO2021107334A1 qui concerne une méthode de fabrication de modules photovoltaïques en autoclave à base de pré-imprégnés ;
- CN210807135U qui décrit des modules photovoltaïques flexibles pour une voiture solaire, avec une face avant en polycarbonate ;
- CN211166388U et CN111391625A qui décrivent des modules photovoltaïques flexibles pour une voiture solaire ;
- KR101423245B1 qui décrit un procédé d'injection de résine dans un moule, avec des cellules ;
- FR3052595A1 qui décrit une lamination de pré-imprégnés avec nid d'abeille ;
- JPH0485970A qui décrit une lamination sous pression de pré-imprégnés de carbone en vue d'intégration dans des panneaux photovoltaïques ;
- WO2018060611A1 qui décrit une encapsulation de cellules photovoltaïques dans des pré-imprégnés en résine epoxy ;
- US20170250299A1 qui décrit une encapsulation de cellules photovoltaïques avec une face avant en matériau composite ;
- FR2934418A1 qui décrit une encapsulation, en une seule étape, de cellules photovoltaïques par infusion ;
- WO2018060611A1 qui décrit une encapsulation de cellules photovoltaïques avec un pré-imprégné thermodurcissable.

Toutefois au-delà des enjeux d'allègement présentés ci-avant, il convient d'ajouter des enjeux de tenue mécanique. Ainsi, pour l'obtention de propriétés mécaniques optimales, la mise en œuvre de matériaux composites peut requérir des pressions importantes, typiquement comprises entre 10.10⁵ Pa et 60.10⁵ Pa. En outre, si les matériaux composites thermodurcissables (-assimilables à des matières non recyclables) présentent l'avantage de pouvoir être mis en œuvre à des températures généralement inférieures à 100°C, les matières thermoplastiques sont par contre mises en œuvre à des températures bien plus importantes, typiquement entre 150 et 250°C. Ces deux contraintes de température et pression, nécessaires pour la tenue mécanique des matériaux composites obtenus, compliquent la mise en œuvre de modules photovoltaïques composés de matières composites au niveau des première et deuxième couches respectivement aux faces avant et arrière. En effet, les matériaux d'encapsulation utilisés dans les architectures conformes à la figure 1 présentent des propriétés de mise en œuvre difficilement compatibles avec ces niveaux de pression et température, du fait de leur tendance au fluage. Ce fluage accroît le risque de déplacements pouvant conduire à la détérioration ou rupture des cellules photovoltaïques ou des connectiques entre ces cellules, notamment dans le cas de l'utilisation de cellules photovoltaïques en silicium.

Par ailleurs, aucune de ces solutions actuellement connues ne permet de parvenir à la fabrication d'un module photovoltaïque qui, outre le fait d'être léger (donc sans verre) et résistant comme l'exigent les besoins des nombreuses applications concrètes et les normes administratives telles que IEC 61215 et IEC 61730, puisse être conformé spatialement suivant une forme gauche, en particulier conformé typiquement avec une courbure qui peut être identique ou différente selon deux axes distincts d'un repère associé au module photovoltaïque, et de surcroit réalisé de manière simple, rapide, efficace et économique, et idéalement en utilisant uniquement des matières recyclables. WO 2013/119113 A1 et EP 2 388 830 A1 décrivent chacun un procédé de fabrication d'un module photovoltaïque par moulage comprenant l'injection d'une résine.

### Objet de l'invention

L'invention a donc pour but de remédier au moins partiellement aux besoins mentionnés précédemment et aux inconvénients relatifs aux réalisations de l'art antérieur.

Il existe notamment un besoin de proposer un procédé de fabrication de modules photovoltaïques qui soient légers et adaptés pour répondre aux besoins de résistance mécanique qui dépendent des applications pratiques et des normes administratives telles que IEC 61215 et IEC 61730, où le procédé de fabrication est simple, rapide, efficace, économique, offrant la possibilité d'utilisation de matières recyclables, permettant une automatisation et une bonne cadence de production, compatible avec la réalisation de modules photovoltaïques de forme gauche, qui offre l'opportunité de conditions de pression et de température d'injection de la résine optimales pour la tenue mécanique du module photovoltaïque, avec une possibilité d'intégrer des matériaux d'encapsulation tout en évitant les risques de fluage de ces derniers durant l'injection de la résine.

L'invention a pour objet un procédé de fabrication d'un module photovoltaïque selon la revendication 1.

L'invention a ainsi pour objet un procédé de fabrication d'un module photovoltaïque où le module photovoltaïque comprend :
- une première couche formée dans un premier matériau composite, transparente, destinée à former une face avant du module photovoltaïque et à recevoir un flux lumineux,
- une deuxième couche formée dans un deuxième matériau composite et destinée à former une face arrière du module photovoltaïque,
- et au moins une cellule photovoltaïque située entre la première couche et la deuxième couche,
le procédé de fabrication comprenant les étapes suivantes :
E1) mise en place d'un empilement initial dans un moule d'assemblage, où l'empilement initial comprend la superposition des éléments suivants :
   - au moins un premier renfort sec destiné à appartenir à la première couche et à entrer dans la composition du premier matériau composite,
   - ladite au moins une cellule photovoltaïque,
   - au moins un deuxième renfort sec destiné à appartenir à la deuxième couche et à entrer dans la composition du deuxième matériau composite,

   l'empilement initial étant tel que ladite au moins une cellule photovoltaïque est située entre l'au moins un premier renfort sec et l'au moins un deuxième renfort sec,
   le moule d'assemblage ayant une aptitude à varier entre une configuration d'ouverture et une configuration de fermeture et comprenant une première partie de moule rigide délimitant une première empreinte ayant une forme complémentaire de la forme de la première couche et une deuxième partie de moule rigide délimitant une deuxième empreinte ayant une forme complémentaire de la forme de la deuxième couche, la première partie de moule et la deuxième partie de moule étant telles que, dans la configuration de fermeture du moule d'assemblage, la première partie de moule et la deuxième partie de moule sont espacées d'un entrefer prédéterminé préférentiellement supérieur ou égal à l'épaisseur de l'empilement initial, et délimitent entre elles une cavité fermée apte à recevoir l'empilement initial,
E2) moulage par transfert de résine, dans laquelle une résine à l'état liquide est injectée dans la cavité d'une manière telle que la résine passe à travers l'au moins un premier renfort sec et à travers l'au moins un deuxième renfort sec,
E3) durcissement de la résine injectée à l'étape E2, l'étape E3 étant réalisée par un ajustement adapté de la température régnant dans la cavité, en fonction de la nature de la résine, la combinaison de l'au moins un premier renfort sec et de la résine à l'état durcie à l'issue de l'étape E3 constituant ledit premier matériau composite et la combinaison de l'au moins un deuxième renfort sec et de la résine à l'état durcie à l'issue de l'étape E3 constituant ledit deuxième matériau composite.

Selon l'invention, l'empilement initial comprend au moins un matériau d'encapsulation, l'empilement initial étant tel que l'au moins un matériau d'encapsulation est situé entre l'au moins un premier renfort sec et l'au moins un deuxième renfort sec. Durant l'étape E2, la température de la résine est adaptée en fonction de l'au moins un matériau d'encapsulation pour que l'au moins un matériau d'encapsulation subisse une fusion au moins partielle sous l'effet de calories transmises par la résine et convertir l'au moins un matériau d'encapsulation en un ensemble encapsulant adhérant d'une part à l'au moins une cellule photovoltaïque et d'autre part à la première couche et/ou à la deuxième couche.

Certains aspects préférés mais non limitatifs sont les suivants. Selon un mode de réalisation, la première empreinte présente une première forme telle que la première couche est conformée selon une première forme gauche à l'issue de l'étape E3 et la deuxième empreinte présente une deuxième forme telle que la deuxième couche est conformée spatialement selon une deuxième forme gauche à l'issue de l'étape E3.

Selon un mode de réalisation, l'étape E2 comprend, après l'étape E1, les étapes suivantes :
- E21) dépression appliquée à la cavité délimitée par le moule d'assemblage dans la configuration de fermeture, par rapport à la pression régnant à l'extérieur de la cavité,
- E22) injection de la résine dans la cavité de manière pressurisée à une pression strictement supérieure à la pression régnant dans la cavité, l'étape E22 étant réalisée après l'étape E21.

Selon un mode de réalisation, l'étape E2 comprend une étape E20 de chauffage de la résine réalisée préalablement à la mise en œuvre de l'étape E22.

Selon un mode de réalisation, l'étape E22, l'injection de la résine est réalisée de manière dirigée suivant une direction préférentielle suivant laquelle la résine circule préférentiellement à l'intérieur de la cavité délimitée par le moule d'assemblage.

Selon un mode de réalisation, le moule d'assemblage comprend au moins une sortie d'évacuation en connexion fluidique avec un système d'aspiration permettant d'établir une dépression dans la cavité délimitée par le moule d'assemblage.

Selon un mode de réalisation, le moule d'assemblage comprend au moins une entrée d'alimentation en connexion fluidique avec un système d'alimentation permettant d'injecter la résine en direction de la cavité délimitée par le moule d'assemblage.

Selon un mode de réalisation, à l'issue de l'étape E1, l'au moins une entrée d'alimentation et l'au moins une sortie d'évacuation sont situées de part et d'autre de l'empilement initial selon une première direction orientée suivant ladite direction préférentielle.

Selon un mode de réalisation, le moule d'assemblage comprend au moins un premier média drainant dans lequel débouche l'au moins une entrée d'alimentation, ledit premier média drainant assurant un drainage de la résine suivant une deuxième direction orientée transversalement à la première direction.

Selon un mode de réalisation, le moule d'assemblage comprend au moins un deuxième média drainant dans lequel débouche l'au moins une sortie d'évacuation, ledit deuxième média drainant assurant un drainage de la résine suivant une deuxième direction orientée transversalement à la première direction.

Selon un mode de réalisation, dans l'étape E21, la pression établie dans la cavité est comprise entre 0,5.10⁵ Pa et 1.10⁵ Pa.

Selon un mode de réalisation, durant l'étape E22, l'injection de la résine est pilotée de sorte que la pression régnant dans la cavité délimitée par le moule d'assemblage est comprise entre 2.10⁵ Pas et 50.10⁵ Pa.

Selon un mode de réalisation, la résine est une résine thermoplastique.

Selon un mode de réalisation, l'étape E3 comprend une étape d'abaissement de la température de l'empilement issu de l'étape E2 par rapport aux conditions présentes durant l'étape E2.

Selon un mode de réalisation, la résine est une résine thermodurcissable.

Selon un mode de réalisation, l'étape E3 comprend une étape de maintien ou d'augmentation de la température de l'empilement issu de l'étape E2 par rapport aux conditions présentes durant l'étape E2.

Selon un mode de réalisation, la première partie de moule et la deuxième partie de moule du moule d'assemblage exercent, sur l'empilement, une pression mécanique durant tout ou partie de l'étape E2 et durant tout ou partie de l'étape E3.

Selon un mode de réalisation, la pression mécanique est comprise entre 90.10⁵ Pa et 150.10⁵ Pa, et plus particulièrement égale à 90.10⁵ Pa, ou égale à 150.10⁵ Pa.

Selon un mode de réalisation, le procédé de fabrication comprend une étape E4 d'ouverture du moule d'assemblage dans laquelle le moule d'assemblage passe de la configuration de fermeture à la configuration d'ouverture, l'étape E4 étant mise en œuvre après l'étape E3.

Selon un mode de réalisation, lors de l'étape E1, l'empilement initial comprend en outre la superposition d'une boîte de jonction destinée à recevoir un câblage nécessaire à l'exploitation du module photovoltaïque.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 représente, en coupe, un exemple classique de module photovoltaïque comportant des cellules photovoltaïques cristallines, selon l'état de la technique.
La figure 1A représente une variante de réalisation de l'exemple de la figure 1 dans laquelle les cellules photovoltaïques sont de type IBC.
La figure 2 représente, en vue éclatée, le module photovoltaïque de la figure 1.
La figure 3 représente, sous forme d'ordinogramme, différentes étapes d'un exemple de procédé de fabrication selon l'invention.
La figure 4 représente, en perspective, un exemple de module photovoltaïque qui peut être obtenu par la mise en œuvre d'un procédé de fabrication selon les étapes de la figure 3.
La figure 5 représente, en perspective, un exemple de moule d'assemblage apte à être utilisé pour la mise en œuvre d'un procédé de fabrication selon les étapes de la figure 3.
La figure 6 est une vue en coupe du moule d'assemblage, dans un plan orienté suivant les première et deuxième directions, visualisant schématiquement la circulation de la résine.
La figure 7 représente une première courbe illustrant un exemple d'évolution, avec différentes phases P1 à P4 successives, de la température adoptée par la pièce à réaliser en fonction du temps dans un premier exemple de procédé de fabrication selon l'invention.
La figure 8 représente schématiquement le comportement du moule d'assemblage et de l'empilement durant une première phase P0 initiale puis durant les différentes phases P1 à P4 correspondant à celles définies sur la figure 7.
La figure 9 représente une deuxième courbe illustrant un exemple d'évolution, avec différentes phases P1 à P4 successives, de la température adoptée par la pièce à réaliser en fonction du temps dans un deuxième exemple de procédé de fabrication selon l'invention exploitant une résine thermodurcissable.
La figure 10 représente schématiquement le comportement du moule d'assemblage et de l'empilement durant une première phase P0 initiale puis durant les différentes phases P1 à P4 correspondant à celles définies sur la figure 9.

### Description détaillée

Les figures 1, 1A et 2 ont déjà été décrites dans la partie relative à l'état de la technique antérieure.

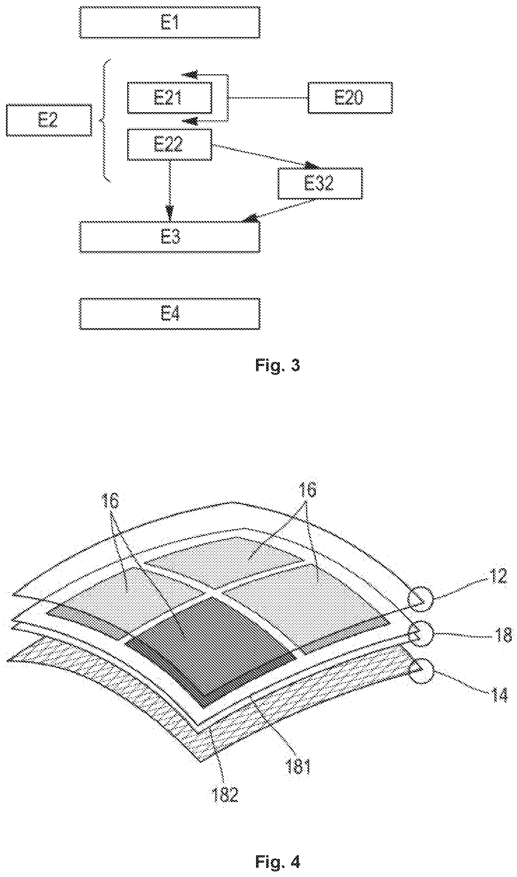

La figure 3 représente, sous forme d'ordinogramme, les différentes étapes d'un exemple de procédé de fabrication selon l'invention.

La mise en œuvre de ces étapes permet par exemple l'obtention d'un module photovoltaïque 10, dont un exemple est représenté sur la figure 4, ayant la particularité de présenter une forme générale gauche, non plane, ce terme « forme gauche » ayant été précédemment défini dans la partie relative à l'état de la technique.

Il est insisté sur le fait que, même si le procédé permet avantageusement de fabriquer un module photovoltaïque 10 de forme gauche de manière simple, économique, efficace et rapide, il reste possible d'envisager d'appliquer ses enseignements pour fabriquer un module photovoltaïque de forme plane. Par forme plane, on entend que chacune de la première couche 12 et de la deuxième couche 14 est conformée sans présenter de courbure selon un axe d'un repère qui serait associé au module photovoltaïque 10, correspondant finalement à une forme générale parallélépipédique.

Le module photovoltaïque 10 qui peut être obtenu grâce au procédé de fabrication décrit dans le présent document comprend par exemple au moins :
- une première couche 12 ayant une forme gauche, formée dans un premier matériau composite, transparente et destinée à former une face avant du module photovoltaïque 10 destinée à recevoir un flux lumineux,
- une deuxième couche 14 ayant une forme gauche, formée dans un deuxième matériau composite, et destinée à former une face arrière du module photovoltaïque 10,
- au moins une cellule photovoltaïque située entre la première couche 12 et la deuxième couche 14,
- un ensemble encapsulant 18 assurant une encapsulation de tout ou partie des cellules photovoltaïques 16.

De manière générale, ladite au moins une cellule photovoltaïque 16 comprend une pluralité de cellules photovoltaïques 16 disposées côte à côté, et reliées électriquement entre elles. Ainsi, et pour simplifier la suite de la description, il sera fait référence à une pluralité de cellules photovoltaïques 16, bien qu'il soit possible d'utiliser indifféremment les termes « au moins une cellule photovoltaïque 16 » à la place.

Selon un premier mode de réalisation, le premier matériau composite est différent du deuxième matériau composite.

Selon un deuxième mode de réalisation, le premier matériau composite est identique au deuxième matériau composite.

De manière générale, chacun du premier matériau composite et du deuxième matériau composite comprend au moins un renfort sec, et une résine. Comme cela sera décrit plus loin, il est possible d'utiliser un renfort sec différent (par sa structure, sa nature ou sa composition) entre le premier matériau composite et le deuxième matériau composite, et une résine identique pour le premier matériau composite et le deuxième matériau composite. De cette manière, il est possible d'obtenir la première couche 12 et la deuxième couche 14 par une seule étape de procédé.

Sur la figure 4 qui représente le cas particulier d'une forme gauche pour les couches 12, 14, les cellules photovoltaïques 16 et l'ensemble encapsulant 18 sont disposés entre la première couche 12 et la deuxième couche 14. Cette disposition serait également vérifiée même dans le cas d'un module photovoltaïque 10 de forme plane.

De manière générale, la première couche 12 est formée en une seule partie monocouche et la deuxième couche 14 est aussi formée en une seule partie monocouche.

Le terme « transparent » signifie dans ce document que la première couche 12 formant la face avant du module photovoltaïque 10 est au moins partiellement transparente à la lumière visible, laissant passer au moins environ 80% de cette lumière. En particulier, la transparence optique, entre 400 et 1200 nm, de la première couche 12 peut être supérieure à 80%.

En référence à la figure 3 maintenant, le procédé de fabrication comprend une étape E1 de mise en place d'un empilement initial 28 dans un moule d'assemblage 20, l'empilement initial 28 comprenant la superposition au moins des éléments suivants :
- au moins un premier renfort sec destiné à appartenir à la première couche 12 à l'issue du procédé de fabrication et à entrer dans la composition du premier matériau composite précédemment défini,
- une ou plusieurs cellules photovoltaïques 16 comme cela a déjà été évoqué,
- au moins un deuxième renfort sec destiné à appartenir à la deuxième couche 14 à la fin du procédé de fabrication et à entrer dans la composition du deuxième matériau composite précédemment défini. L'empilement initial 28 comprend au moins un matériau d'encapsulation. L'au moins un matériau d'encapsulation est situé entre l'au moins un premier renfort sec et l'au moins un deuxième renfort sec.

Au sein de l'empilement initial 28, la pluralité de cellules photovoltaïques 16 est située entre l'au moins un premier renfort sec et l'au moins un deuxième renfort sec.

Ce qui distingue le premier renfort sec et le deuxième renfort sec d'un point de vue sémantique, c'est ici uniquement le fait d'appartenir respectivement à la première couche 12 et à la deuxième couche 14 une fois que le procédé de fabrication sera terminé. Ainsi, et selon un mode de réalisation, il est possible que le premier renfort sec soit identique au deuxième renfort sec au niveau de sa nature, et/ou de son organisation (c'est-à-dire le nombre de plis et leur orientation relative), et/ou de son taux de renfort.

Cependant, et alternativement, il est possible que le premier renfort sec diffère du deuxième renfort sec selon un ou plusieurs des paramètres cités ci-avant, c'est-à-dire sa nature, son organisation, ou son taux de renfort.

Selon l'invention, l'empilement initial 28 comprend au moins un matériau d'encapsulation 181, 182, l'empilement initial 28 étant tel que l'au moins un matériau d'encapsulation 181, 182 est situé entre l'au moins un premier renfort sec et l'au moins un deuxième renfort sec. À l'issue du procédé de fabrication chacun des matériaux d'encapsulation 181, 182 présents entrera dans la constitution de l'ensemble encapsulant 18 déjà évoqué. Le premier matériau d'encapsulation 181 est placé entre les cellules photovoltaïques 16 et ce qui deviendra la première couche 12 à la fin du procédé de fabrication. Le deuxième matériau d'encapsulation 182 est placé, quant à lui, entre les cellules photovoltaïques 16 et ce qui deviendra la deuxième couche 14 à la fin du procédé de fabrication.

Par le terme « encapsulant » il faut comprendre que la pluralité de cellules photovoltaïques 16 est alors disposée dans un volume, par exemple hermétiquement clos vis-à-vis des liquides, au moins en partie formé par au moins deux couches de matériau(x) d'encapsulation, réunies entre elles, à l'issue du procédé de fabrication qui sera décrit, pour former l'ensemble encapsulant 18.

En effet, initialement, c'est-à-dire avant la mise en œuvre de l'étape E2 qui sera décrite plus loin, l'ensemble encapsulant 18 non encore finalisé est constitué par au moins une couche du matériau d'encapsulation 181, qui est alors situé entre la pluralité de cellules photovoltaïques 16 et l'au moins un premier renfort sec et/ou par au moins une couche du matériau d'encapsulation 182, qui est alors situé entre la pluralité de cellules photovoltaïques 16 et l'au moins un deuxième renfort sec. Toutefois, c'est généralement pendant l'étape E2 que ce(s) matériau(x) d'encapsulation 181 et/ou 182 va(vont) subir une fusion au moins partielle pour former, après refroidissement, l'ensemble encapsulant 18 solidifié dans lequel sont alors noyées les cellules photovoltaïques 16 hermétiquement.

La mise en œuvre de l'étape E1 peut être automatisée via des robots de manipulation adaptés, manuelle ou semi-automatique. Au moment de leur mise en œuvre, les premier et deuxième renforts secs ne sont pas imprégnés par une résine. Dans un exemple comparatif, ne faisant pas partie de l'invention, dépourvu de l'ensemble encapsulant 18 à l'issue du procédé de fabrication, l'au moins un premier renfort sec est, à l'étape E1, en situation de faire face ou d'être au contact direct avec la face avant des cellules photovoltaïques 16, tandis que l'au moins un deuxième renfort sec est, à l'étape E1, en situation de faire face ou d'être au contact direct avec la face arrière des cellules photovoltaïques 16.

Par « sec », on entend que chacun des premier et deuxième renforts ne comprend pas encore de résine, au contraire de produits connus dans le domaine des matériaux composites de type pré-imprégné ou de type plaque de composite thermoplastique renforcé de fibres (une telle plaque étant un assemblage de plis composites déjà compactés).

La composition du premier renfort sec peut être identique à la composition du deuxième renfort sec. Alternativement, la composition du premier renfort sec peut être différente de la composition du deuxième renfort sec. Cela peut dépendre par exemple de la transparence nécessaire pour la première couche 12, des résistances mécaniques à obtenir, des coûts ou des besoins ou non de transparence de la deuxième couche 14.

A l'étape E1, il est possible de prévoir un ou plusieurs premier(s) renfort(s) sec(s). Dans le cas où il y en a plusieurs, ils pourront être superposés dans une organisation où tout ou partie de la surface de l'un des premiers renforts secs présents recouvre tout ou partie de la surface d'un autre des premiers renforts secs présents. Dans ce cas, chaque premier renfort sec peut être disposé de sorte qu'un maillage d'un des premiers renforts secs soit dans le même sens qu'un autre premier renfort sec, ou que la superposition desdits premiers renforts secs soit mise en œuvre en prévoyant un décalage angulaire entre les maillages des premiers renforts secs, par exemple égal à 45° ou 90°.

De même, il est possible de prévoir un ou plusieurs deuxième(s) renfort(s) sec(s). Dans le cas où il y en a plusieurs, ils pourront être superposés dans une organisation où tout ou partie de la surface de l'un des deuxièmes renforts secs présents recouvre tout ou partie de la surface d'un autre des deuxièmes renforts secs présents. Dans ce cas, chaque deuxième renfort sec peut être disposé de sorte qu'un maillage d'un des deuxièmes renforts secs soit dans le même sens qu'un autre deuxième renfort sec, ou que la superposition desdits deuxièmes renforts secs soit mise en œuvre en prévoyant un décalage angulaire entre les maillages des deuxièmes renforts secs, par exemple égal à 45° ou 90°.

Chaque premier renfort sec et chaque deuxième renfort sec est un élément connu en soi dans le domaine technique des matériaux composites. Il s'agit de l'armature apte à reprendre l'essentiel des efforts mécaniques qui seront appliqués au premier matériau composite et au deuxième matériau composite, respectivement. L'Homme du Métier connait parfaitement de tels renforts et sait qu'il s'agit d'éléments (fibres) se présentant sous la forme de fils, d'une nappe tissée ou non tissée, de tresses, ou une combinaison de ces éléments, par exemple par tissage ou sergé, ou sous la forme d'une nappe de fibres en vrac non tissées (mat). Pour obtenir le premier matériau composite dans lequel la première couche 12 est formée ainsi que le deuxième matériau composite dans lequel la deuxième couche 14 est formée, après l'étape E1 il est nécessaire de noyer chaque premier renfort sec dans une résine afin que celle-ci polymérise ensuite dans le cas où la résine présente des caractéristiques thermoplastiques ou afin que celle-ci réticule ensuite dans le cas où la résine présente des caractéristiques thermodurcissables. La même résine sera avantageusement utilisée pour la consolidation du premier matériau composite et du deuxième matériau composite respectivement des première et deuxième couches 12, 14. Il s'agit d'un avantage en terme de simplicité de mise en œuvre ainsi que de facilité de gestion de la résine. En outre, l'utilisation d'une seule résine permet d'avoir une bonne compatibilité chimique entre la première couche 12 et la deuxième couche 14, ce qui permet de d'améliorer l'intégrité structurelle du module photovoltaïque 10.

La composition de chaque premier renfort sec est préférentiellement du verre, permettant d'obtenir la transparence souhaitée pour la première couche 12, afin de laisser passer le flux lumineux destiné à être reçu par la face avant de la première couche 12 et permettre à une fraction (environ 80%) la plus élevée possible de ce flux lumineux d'être incidente sur les cellules photovoltaïques 16 sous-jacentes. La composition de chaque deuxième renfort sec peut, quant à elle, notamment être choisie parmi du verre, du carbone, de l'aramide, des fibres naturelles choisies parmi le chanvre, le lin, la soie entres autres.

Typiquement, chacun des premiers et deuxièmes renforts secs peut prévoir une disposition de type mat ou tissée, par exemple sergé (il s'agit d'une armature tissée qui présente de fines côtes obliques), ou encore triaxiaux ou quadri-axiaux, ou non tissée. L'ensimage (il s'agit du traitement de surface du renfort destiné à faciliter les opérations ultérieures), la composition, la disposition ou encore la longueur (la forme comprenant comme paramètre le fait de savoir si les fibres sont courtes (0,1 à 1 mm), longues (1 à 50 mm) ou continues (supérieure à 50 mm), voire la présence possible de charges renforçantes) de chaque premier renfort sec et de chaque deuxième renfort sec peuvent être adaptés en fonction de critères tels que la transparence à obtenir, la résistance mécanique à obtenir, le coût, la masse surfacique et/ou l'épaisseur du module photovoltaïque 10. Il est notamment préférable d'optimiser la transparence du premier matériau composite dans lequel la première couche 12 est formée.

Dans un exemple particulier non limitatif qui donne satisfaction dans les essais et les simulations, il peut être prévu la présence de trois premiers renforts secs superposés les uns aux autres. Selon un mode de réalisation, les premiers renforts secs sont superposés de sorte qu'ils soient orientés dans le sens du flux, ou à 45° par rapport au sens du flux de la résine lors de l'étape E2 qui sera décrite plus loin. Ces premiers renforts secs présentent une disposition de type sergé, ayant chacun une composition en verre et une masse surfacique de 285 g/m², conférant avantageusement une très bonne transparence à la première couche 12 à obtenir ensuite. Il peut être également prévu la présence de trois deuxièmes renforts secs superposés les uns aux autres, présentant une disposition de type sergé, ayant chacun une composition en verre et une masse surfacique de 285 g/m². Ces renforts peuvent être utilisés dans les étapes E2, E3 décrites plus loin en combinaison avec une résine de type polyépoxyde, encore appelée polymère époxyde ou communément « époxy ». A l'issue de l'étape E3, la première couche 12 qui présente une épaisseur inférieure à 2 mm, préférentiellement de l'ordre de 0,5 mm, peut alors présenter une masse surfacique comprise entre 120 et 200 g/m², et préférentiellement de l'ordre de 160 g/m² pour des raisons de légèreté et d'encombrement. A l'issue de l'étape E3, la deuxième couche 14 qui présente une épaisseur inférieure à 2 mm, préférentiellement de l'ordre de 0,5 mm, peut aussi présenter une masse par unité de surface comprise entre 120 et 200 g/m², et préférentiellement de l'ordre de 160 g/m² pour des raisons de légèreté et d'encombrement.

Dans l'exemple de la figure 4, la première couche 12 est conformée selon une courbure qui peut être identique ou différente suivant deux axes distincts d'un repère associé au module photovoltaïque 10. De manière complémentaire, la deuxième couche 14 est conformée selon une courbure qui peut être identique ou différente suivant deux axes distincts d'un repère associé au module photovoltaïque 10. Selon un mode de réalisation, les courbures sont identiques pour la première couche 12 et pour la deuxième couche 14. Ainsi, et de manière avantageuse, il est possible de garantir une complémentarité de formes pour les première et deuxième couches 12, 14, et d'obtenir une homogénéité d'épaisseur de la première couche 12, et de la deuxième couche 14.

Les cellules photovoltaïques 16 peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), les perovskites, entre autres..

Les cellules photovoltaïques 16 sont interconnectées entre elles, par exemple sous la forme de guirlande suivant une bande. L'espacement entre deux cellules photovoltaïques 16 voisines, ou encore consécutives ou adjacentes, peut être supérieur ou égal à 1 mm, notamment compris entre 1 et 30 mm, et de préférence égal à 2 mm. L'usage de connectiques à résistance mécanique accrue peut être envisagé, suivant les applications et notamment en fonction de la pression à laquelle elles doivent résister.

L'étape E1 peut donc comprendre une étape initiale consistant à interconnecter les cellules photovoltaïques 16 entre elles, afin de constituer un ensemble interconnecté apte à être mis en place entre l'au moins un premier renfort sec et l'au moins un deuxième renfort sec.

Comme y la présence des matériaux d'encapsulation 181, 182 destinés à subir une fusion au moins partielle sous l'effet de l'apport de calories par la résine injectée à l'étape E2 ultérieure, alors cet ensemble interconnecté sera mis en place entre les matériaux d'encapsulation 181, 182 durant ladite étape initiale.

Par ailleurs, les cellules photovoltaïques 16 peuvent présenter une épaisseur comprise entre 1 et 300 µm, notamment entre 1 et 200 µm, et avantageusement entre 70 µm et 160 µm si elles sont à base de silicium cristallin, permettant de limiter le poids et l'encombrement.

Le module photovoltaïque 10 peut en outre comporter une boîte de jonction 7 (non visible sur la figure 4), destinée à recevoir le câblage nécessaire à l'exploitation du module photovoltaïque 10 et pouvant être positionnée en face avant ou en face arrière du module photovoltaïque 10, préférentiellement en face avant. La manière de réaliser cette boîte de jonction n'est pas limitative en soi et toute technique connue peut être utilisée. Il peut par exemple s'agir d'une organisation reprenant les enseignements et principes des figures 1, 1A et 2. Par exemple, la boîte de jonction 7 peut être intégrée à l'empilement initial 28 lors de l'étape E1 de mise en place de l'empilement initial. Ainsi, la boîte de jonction 7 peut être superposée avec les autres éléments de l'empilement initial 28 de manière à ce qu'elle soit intégrée au module photovoltaïque 10 au moment de l'étape E2 de moulage.

Le moule d'assemblage 20 dans lequel est mis en place l'empilement initial 28 lors de l'étape E1 présente une aptitude à varier entre une configuration d'ouverture et une configuration de fermeture. Le moule d'assemblage 20 comprend une première partie de moule 22 rigide délimitant une première empreinte 220 ayant une forme complémentaire de la forme de la première couche 12 recherchée et une deuxième partie de moule 24 rigide délimitant une deuxième empreinte 240 ayant une forme complémentaire de la forme de la deuxième couche 14 recherchée.

Dans un mode de réalisation de l'étape E1, l'empilement initial 28 est directement réalisé dans le moule d'assemblage 20. Alternativement, l'empilement initial 28 est au moins partiellement réalisé à l'extérieur du moule d'assemblage 20 avant d'être mis en place et éventuellement finalisé dans le moule d'assemblage 20. Ainsi, selon ce mode de réalisation, l'étape E1 comprend une étape de formation de l'empilement initial 28 dans lequel les éléments suivants sont superposés :
- l'au moins un premier renfort sec destiné à appartenir à la première couche 12 et à entrer dans la composition du premier matériau composite,
- ladite pluralité de cellules photovoltaïques 16,
- l'au moins un deuxième renfort sec destiné à appartenir à la deuxième couche 14 et à entrer dans la composition du deuxième matériau composite.

L'empilement initial 28 comprend au moins un matériau d'encapsulation. L'au moins un matériau d'encapsulation est situé entre l'au moins un premier renfort sec et l'au moins un deuxième renfort sec. Par ailleurs, l'étape E1 peut comprendre une étape de laminage, mise en œuvre entre l'étape de formation de l'empilement initial et l'étape de mise en place de l'empilement initial 28 dans le moule d'assemblage, ladite étape de laminage comprenant le laminage de l'empilement initial 28 pour former un empilement initial 28 laminé utilisé comme empilement initial 28 pour la étape suivantes du procédé de fabrication, l'étape E1 de mise en place de l'empilement initial 28 dans le moule d'assemblage étant alors mise en œuvre avec l'empilement initial 28 laminé. Selon un mode de réalisation, l'étape de laminage comprend en outre le laminage de l'empilement initial 28 et de l'au moins un matériau d'encapsulation 181, 182.

La mise en œuvre de l'étape E1 peut être automatisée via des robots de manipulation adaptés, manuelle ou semi-automatique. Au moment de sa mise en œuvre, les premier et deuxième renforts secs, par exemple en verre, ne sont pas imprégnés par une résine.

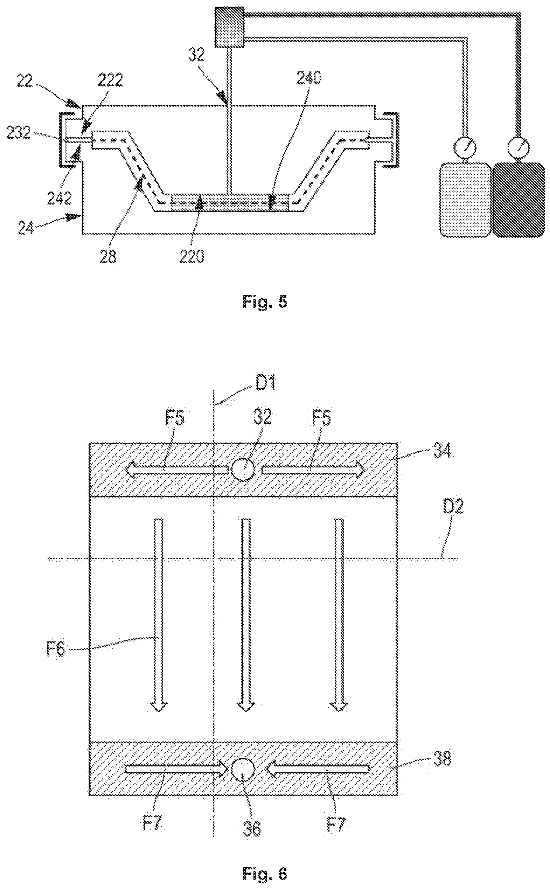

Un exemple de tel moule d'assemblage 20 est illustré sur la figure 5, lequel est adapté à l'obtention du module photovoltaïque 10 de la figure 4.

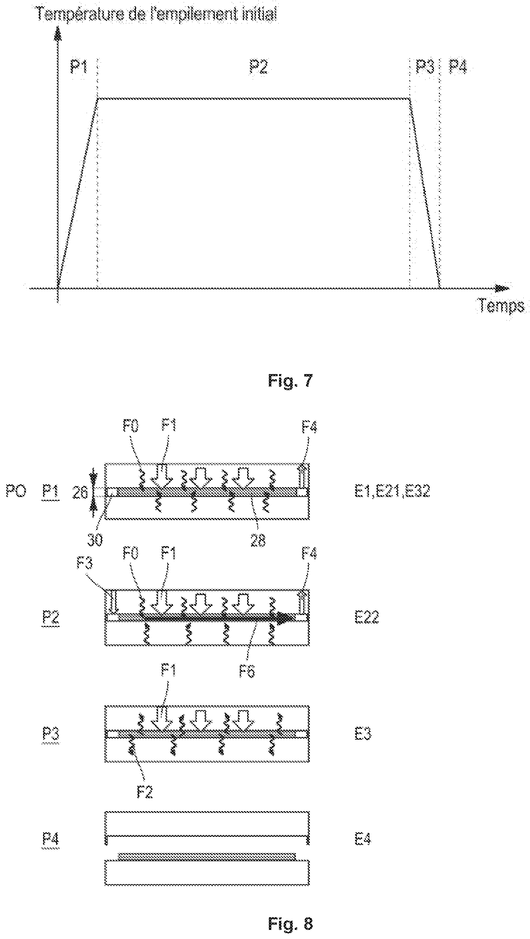

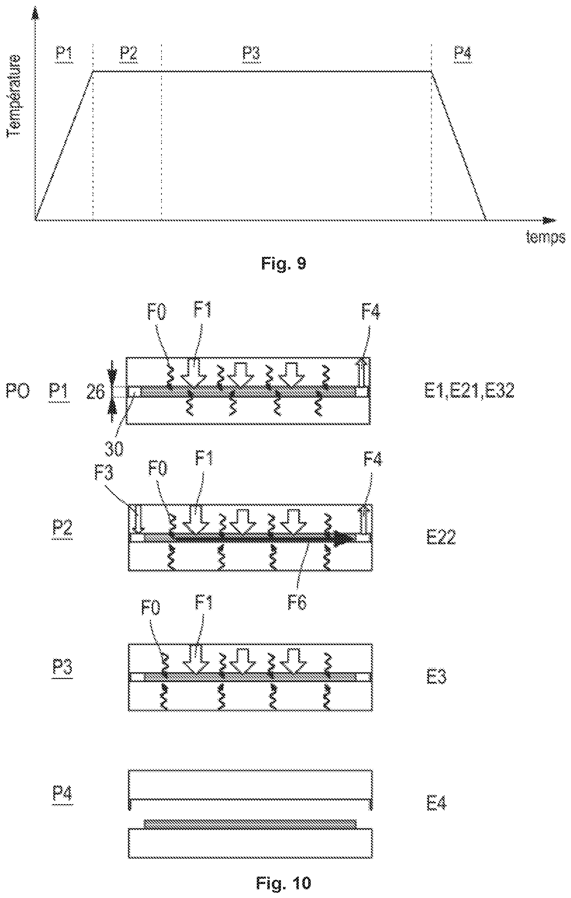

Le moule d'assemblage 20 peut varier entre la configuration de fermeture (occupées dans les phases P1 à P3 sur les figures 8 et 10) et la configuration d'ouverture illustrée sur la figure 5. La configuration d'ouverture peut être adoptée pour la mise en œuvre de l'étape E1, puis permettre un retrait du module photovoltaïque 10 hors du moule d'assemblage 20 après sa fabrication ou pour la mise en œuvre de l'étape E3 et/ou de l'étape E4, celles-ci étant décrites plus loin. En fonction de la conception du moule d'assemblage 20, le passage de la configuration de fermeture à la configuration d'ouverture et réciproquement peut se faire par un mouvement relatif entre la première partie de moule 22 et la deuxième partie de moule 24, ce mouvement relatif étant une combinaison entre :
- une translation suivant un premier axe du repère associé au module photovoltaïque 10 à fabriquer et orienté suivant la direction selon laquelle les différentes couches et éléments de l'empilement sont empilés,
- et/ou un pivotement autour d'un deuxième axe de ce repère orienté transversalement au premier axe.

La première partie de moule 22 et la deuxième partie de moule 24 sont telles que, dans la configuration de fermeture du moule d'assemblage 20, la première partie de moule 22 et la deuxième partie de moule 24 sont espacées d'un entrefer prédéterminé 26 préférentiellement supérieur ou égal à l'épaisseur de l'empilement initial 28 et délimitent entre elles une cavité 30 fermée apte à recevoir l'empilement initial 28. Par exemple, ladite cavité 30 est étanche. L'entrefer prédéterminé 26 et la cavité 30 sont schématisés sur les figures 8 et 10. Un premier joint 222 de la première partie de moule 22 vient en contact contre un deuxième joint 242 de la deuxième partie de moule 24 afin d'assurer une étanchéité telle que, dans la configuration de fermeture, la cavité 30 peut être mise dans des conditions d'abord de dépression puis de surpression durant l'étape E3, en comparaison de la pression ambiante à l'extérieur du moule d'assemblage 20. Il est éventuellement possible d'avoir une dépression dans la cavité 30 sans mise en pression mécanique (cette pression étant symbolisée sur les figures par les flèches notées F1) de l'empilement initial 28.

La mise en place de l'entrefer prédéterminé 26 dans la configuration de fermeture peut résulter de la mise en butée mécanique d'une première butée solidaire de la première partie de moule 22 contre une deuxième butée solidaire de la deuxième partie de moule 24, la mise en butée mécanique de ces première et deuxième butées s'accompagnant de la mise en place de l'étanchéité décrite précédemment au moyen des premier et deuxième joints 222, 242.

La différence entre la valeur de l'entrefer prédéterminé 26 et l'épaisseur de l'empilement initial 28, cette différence étant supérieure ou égale à zéro et potentiellement réglable, permet concrètement d'influer sur l'épaisseur de la première couche 12 formée dans le premier matériau composite et sur l'épaisseur de la deuxième couche 14 formée dans le deuxième matériau composite et sur l'épaisseur et/ou la pression interne de la quantité de résine :
- qui enrobe hermétiquement les cellules photovoltaïques 16 et les assemble à la première couche 12 et à la deuxième couche 14.
- et/ou qui assemble la première couche 12 au matériau d'encapsulation 181 et/ou aux cellules photovoltaïques 16,
- et/ou qui assemble la deuxième couche 14 au matériau d'encapsulation 182 et/ou aux cellules photovoltaïques 16.

Préférentiellement, le moule d'assemblage 20 comprend des éléments de réglage configurés de sorte à ajuster la valeur de l'entrefer prédéterminé 26, permettant finalement de faire varier la valeur de l'épaisseur du module photovoltaïque 10 fabriqué.

Selon un mode de réalisation, ces éléments de réglage peuvent être choisis parmi :
- des éléments permettant de varier la position de la première butée par rapport au reste de la première partie de moule 22,
- des éléments permettant de varier la position de la deuxième butée par rapport au reste de la deuxième partie de moule 24,
- des cales de hauteurs variables aptes à être positionnées entre la première butée et la deuxième butée dans la configuration de fermeture du moule d'assemblage 20.

Comme l'invention prévoit la présence d'un ensemble encapsulant 18, le procédé de fabrication peut comprendre une étape consistant à pré-laminer l'au moins un matériau d'encapsulation 181, 182 présent. Cette étape peut être réalisée préalablement à la mise en œuvre de l'étape E1 ou peut également être opérée directement dans le moule d'assemblage 20, avant la mise en œuvre de l'étape E2.

En référence à la figure 3 toujours, le procédé de fabrication comprend ensuite une étape E2 de moulage par transfert de résine, dans laquelle une résine à l'état liquide est injectée dans la cavité 30 d'une manière telle que la résine passe à travers l'au moins un premier renfort sec ainsi qu'à travers l'au moins un deuxième renfort sec. De manière avantageuse, utiliser une résine ayant une viscosité maximale comprise entre 300 mPa.s et 400 mPa.s permet d'injecter correctement la résine pour la mise en œuvre de l'étape E2.

Selon un mode de réalisation dans lequel la cavité 30 est étanche, après que des conditions de vide ont été appliquées préalablement à l'injection de la résine, cette injection de la résine implique d'abord une augmentation progressive et importante de la pression dans la cavité 30, impliquant un effet avantageux de compactage des différents composants du module photovoltaïque 10 durant l'injection de la résine. Dans l'étape E2, il est bien compris que le moulage est obtenu par le transfert sous pression de la résine injectée, cette pression pouvant par exemple atteindre jusqu'à 50.10⁵ Pa pour le cas d'une résine thermodurcissable, comme par exemple une résine époxy, ou atteindre jusqu'à 20.10⁵ Pa pour le cas d'une résine thermoplastique, comme par exemple une résine acrylique, par exemple connue sous la dénomination commerciale « Elium ». Cet effet de compactage de plusieurs dizaines de bars (où 1 bar est égal à 10⁵ Pa) combiné à des conditions de température élevée (notamment supérieure à 100°C voire idéalement au-dessus de 150°C et inférieure à 250°C) offrent l'opportunité de conditions de pression et de température d'injection de la résine optimales pour conférer une bonne tenue mécanique du module photovoltaïque 10. Ces dispositions sont obtenues en s'affranchissant avantageusement des risques de fluage qui existaient dans les solutions existantes. L'étape E2 de moulage par transfert de la résine, cette technique étant également connue sous l'acronyme « RTM » pour « Resin Transfer Molding » selon la terminologie anglo-saxonne appropriée, est opérée dans le moule d'assemblage 20 délimitant la cavité 30 alors fermée et accouplé possiblement à une presse chauffante, permettant d'atteindre les plages de pression et de température nécessaires à l'injection de la résine dans l'empilement durant l'étape E2 puis à sa consolidation durant l'étape E3. À la différence des techniques utilisant des fibres de renfort pré-imprégnées (fils ou tissus déjà chargés de résine), la technique RTM utilise des renforts secs, c'est-à-dire que l'apport de résine se fait en phase finale du procédé, une fois la structure de renfort de la pièce entièrement construite.

Il est également possible de mettre en œuvre l'étape E2 alors que la cavité 30 n'est pas étanche. Dans ce cas, les premier et deuxième joints 222, 242 comprennent des évents atmosphériques 232 configurés pour laisser passer l'air. Avantageusement, de tels évents sont disposés à des extrémités de la cavité 30, de sorte que la résine chasse l'air présent dans la cavité au niveau des évents. Bien que ce mode de réalisation avec une cavité 30 perméable à l'air donne des résultats satisfaisant, il est préférable d'utiliser une cavité 30 étanche, qui diminue le risque de piéger des bulles d'air dans l'ensemble encapsulant 18.

L'utilisation de squelettes de cellules photovoltaïques 16 adéquatement conçus peut permettre d'éviter leur casse lors de l'étape E2 sous sollicitation mécanique importante (la pression pouvant atteindre environ 50.10⁵ Pa durant l'opération de moulage par transfert de résine époxy), et d'assurer leur tenue aux principaux essais de vieillissement de la norme IEC 61215, notamment l'essai en charge mécanique à +/- 2400 Pa.

Comme cela est visible sur la figure 3, le procédé de fabrication comprend ensuite une étape E3 consistant à assurer un durcissement de la résine préalablement injectée à l'étape E2. L'étape E3 est réalisée par un ajustement adapté de la température régnant dans la cavité 30, en fonction de la nature de la résine injectée à l'étape E2. La combinaison de l'au moins un premier renfort sec et de la résine à l'état durcie à l'issue de l'étape E3 constitue le premier matériau composite. La combinaison de l'au moins un deuxième renfort sec et de la résine à l'état durcie à l'issue de l'étape E3 constitue le deuxième matériau composite. Le durcissement de la résine peut se faire par polymérisation dans le cas où la résine présente des caractéristiques thermoplastiques (cela nécessitant un abaissement de la température) ou par réticulation dans le cas où la résine présente des caractéristiques thermodurcissables (cela nécessitant un maintien ou une augmentation de la température pendant une certaine durée pour provoquer la réticulation).

L'empilement initial 28 comprend au moins un matériau d'encapsulation 181, 182. Il est prévu que durant l'étape E2, la température de la résine soit adaptée en fonction de l'au moins un matériau d'encapsulation 181, 182 pour que l'au moins un matériau d'encapsulation 181, 182 subisse une fusion au moins partielle sous l'effet de calories transmises par la résine et convertir l'au moins un matériau d'encapsulation 181, 182 en l'ensemble encapsulant 18 déjà décrit, permettant à ce dernier d'adhérer d'une part à la pluralité de cellules photovoltaïques 16 et d'autre part à la première couche 12 par l'intermédiaire de la couche de matériau d'encapsulation 181 et/ou à la deuxième couche 14 par l'intermédiaire de la couche de matériau d'encapsulation 182.

Il est donc possible de mettre en œuvre des modules photovoltaïques 10 plans ou de formes gauches, à base de cellules photovoltaïques 16 par exemple en silicium cristallin, avec ou sans ensemble encapsulant 18, avec le premier matériau composite et le deuxième matériau composite respectivement en première face 12 avant et en deuxième face 14 arrière du module photovoltaïque 10, par l'étape E2 de moulage par transfert de résine. Le premier matériau composite et le deuxième matériau composite utilisés sont mis en œuvre directement au cours du procédé à partir de l'au moins un premier renfort sec à intégrer au premier matériau composite et de l'au moins un deuxième renfort sec à intégrer au deuxième matériau composite, par l'utilisation de l'unique résine ainsi injectée puis durcie. Le procédé de fabrication permet sa mise en œuvre dans une gamme température-pression permettant d'obtenir les propriétés mécaniques optimales des premier et deuxième matériaux composites respectivement en première face 12 avant et en deuxième face 14 arrière du module photovoltaïque 10. Comme il le sera précisé plus loin, la résine injectée à l'étape E2 peut être une matrice thermodurcissable ou une matrice thermoplastique.

De préférence, l'au moins un matériau d'encapsulation 181, 182 présente une épaisseur comprise entre 100 µm et 2000 µm et est choisi parmi :
- un élastomère thermoplastique lui-même choisi parmi : polyoléfine, polyuréthane thermoplastique (TPU), polyvinyl butyral (PVB), polyoléfine fonctionnelle, ionomère ;
- un élastomère thermodurcissable lui-même choisi parmi : poly(éthylène-acétate de vinyle) (EVA), une silicone réticulée, une polyoléfine réticulée (POE), un polyuréthane réticulé (PUR).

La sélection ci-dessus du matériau d'encapsulation 181,182 est réalisée pour éviter ou limiter les phénomènes de fluage qui peuvent avoir lieu du fait de la pression importante (plusieurs dizaines de bars) ou du contact avec les parties de moule 22, 24, ainsi que des phénomènes de turbulences par interaction entre la résine et le(s) matériau(x) d'encapsulation 181, 182 qui pourraient être induites par le ramollissement d'un matériau d'encapsulation 181, 182 qui serait mal sélectionné.

Il est donc bien compris qu'à l'issue de l'étape E1, la résine nécessaire à l'obtention et au durcissement est absente. Après la mise en place de cet empilement sec dans le moule d'assemblage 20, c'est à l'étape E2 que la même et unique résine est injectée sous pression et à chaud, conjointement :
- dans le volume qui va constituer la première couche 12,
- dans le volume qui va constituer la deuxième couche 14,
- et dans tout volume potentiellement présent spatialement autour des cellules photovoltaïques 16, en contact direct avec celles-ci ou autour de l'au moins un matériau d'encapsulation 181, 182.

Dans le cas où il n'est pas prévu d'ensemble encapsulant 18, selon un exemple comparatif, ne faisant pas partie de l'invention, alors la résine vient remplir durant l'étape E2 (avant le durcissement de l'étape E3) tout le volume présent spatialement autour des cellules photovoltaïques 16. La résine remplit alors après l'étape E3 :
- une première fonction consistant à enrober hermétiquement les cellules photovoltaïques 16 en substitution à l'ensemble encapsulant 18,
- une deuxième fonction qui consiste à assurer la consolidation des première et deuxième couches 12, 14 en entrant naturellement dans la composition respectivement du premier matériau composite et du deuxième matériau composite en combinaison avec l'au moins un premier renfort sec et l'au moins un deuxième renfort sec, respectivement,
- une troisième fonction consistant à faire adhérer les différentes couches de l'empilement du module photovoltaïque 10 entre elles.

Très avantageusement, ces différentes fonctions sont obtenues de manière très simple, rapide, efficace, économique, automatisable aisément et potentiellement avec une bonne cadence de production, par la mise en œuvre d'une unique étape E2 de moulage par transfert de résine où il suffit d'injecter la résine sous pression et à chaud de manière idoine.

Dans le cas de l'usage d'une résine thermoplastique et où on peut en particulier s'affranchir avantageusement de l'ensemble encapsulant 18, le caractère recyclable est facilité par rapport à la variante où l'ensemble encapsulant 18 est présent, car il n'y a alors qu'un seul type de résine (polymère) présent dans le module photovoltaïque 10.

Selon l'invention, il est prévu l'ensemble encapsulant 18. La résine remplit et comble avant durcissement :
- tout le volume présent spatialement entre l'au moins un premier renfort sec et le matériau d'encapsulation 181 agencé du côté de l'au moins un premier renfort sec,
- tout le volume qui correspond à la première couche 12,
- tout le volume présent spatialement entre l'au moins un deuxième renfort sec et le matériau d'encapsulation 182 agencé du côté de l'au moins un deuxième renfort sec,
- tout le volume qui correspond à la deuxième couche 14,

La résine remplit alors, après l'étape E3 :
- une première fonction consistant à solidariser l'ensemble encapsulant 18 et/ou les cellules photovoltaïques 16 avec la première couche 12 d'une part et avec la deuxième couche 14 d'autre part, assurant finalement la cohésion des différentes parties du module photovoltaïque 10 entre elles pour former un objet d'un seul tenant,
- une deuxième fonction qui consiste à assurer la consolidation des première et deuxième couches 12, 14 en entrant naturellement dans la composition respectivement du premier matériau composite et du deuxième matériau composite en combinaison avec l'au moins un premier renfort sec et l'au moins un deuxième renfort sec, respectivement.

Dans ce qui précède et qu'il y ait présence de l'ensemble encapsulant 18 ou non, un avantage est que toutes ces fonctions sont obtenues par la résine elle-même, moyennant une unique opération consistant au moulage par transfert de résine sous pression et à chaud obtenu par simple injection adaptée de la résine, puis son refroidissement. Cela permet que le procédé de fabrication présente un nombre très faible d'étapes, ce qui favorise évidemment la simplicité, la rapidité, la limitation des coûts, une possibilité d'automatisation aisée et de cadences intéressantes.

L'adhésion des différents composants et couches au sein du module photovoltaïque 10, pour en faire un objet d'un seul tenant, est obtenue essentiellement par la présence de la résine injectée suivant l'étape E2 et, comme l'ensemble encapsulant 18 est prévu, sous l'effet supplémentaire et avantageux de l'apport calorifique à l'au moins un matériau d'encapsulation 181, 182 (en vue de parvenir à sa fusion au moins partielle) que provoquent l'injection et la circulation de la résine sous pression et à chaud induites par la mise en œuvre de l'étape E2. Autrement dit, grâce à la présence de l'ensemble encapsulant 18, la résine chauffée et injectée permet non seulement la consolidation recherchée conjointe de la première couche 12 et de la deuxième couche 14 (par polymérisation dans le cas où la résine est thermoplastique ou par réticulation dans le cas où la résine est thermodurcissable) mais également l'assemblage de la première couche 12 et de la deuxième couche 14 aux cellules photovoltaïques 16 et/ou à l'ensemble encapsulant 18, au moyen d'une seule et même résine, voire facultativement en plus un enrobage hermétique des cellules photovoltaïques 16 en substitution à l'ensemble encapsulant 18.

Ainsi, on se sert de la résine injectée par l'étape E2, identique pour les première et deuxième couches 12, 14, pour faire d'une part l'assemblage de l'empilement et en même temps pour faire la fabrication proprement dite de la première couche 12 avant et de la deuxième couche 14 arrière ; toutes ces actions se pratiquent globalement en une seule opération couvrant les étapes E2 à E4.

Tous ces avantages peuvent en outre être obtenus pour des modules photovoltaïques légers (notamment compatibles avec une large gamme de masse par unité de surface pouvant aller de quelques kg/m² jusqu'à plusieurs dizaines de kg/m²), adaptés pour répondre à des besoins sévères de résistance mécanique (notamment suivant une résistance mécanique conformes aux normes administratives classiques dans le domaine, typiquement les normes IEC 61215 et IEC 61730), possiblement de forme gauche, tout en s'affranchissant de tout risque de fluage et/ou de cloquage des matériaux d'encapsulation 181, 182, ce qui garantit une grande répétabilité du procédé de fabrication et une excellente fiabilité des modules photovoltaïques 10 fabriqués.

Pour entrer dans la composition du premier matériau composite à la suite des étapes E3 et E4, il est possible que l'au moins un premier renfort sec soit associé à au moins un autre renfort sec présentant ou non une autre nature en terme de composition, de forme, de disposition, d'orientation, d'épaisseur etc. Symétriquement, pour entrer dans la composition du deuxième matériau composite à la suite des étapes E2 et E3, il est possible que l'au moins un deuxième renfort sec soit associé à au moins un autre renfort sec présentant ou non une autre nature en terme de composition, de forme, de disposition, d'orientation, d'épaisseur etc.

La réussite du procédé de fabrication peut dépendre du choix des cellules photovoltaïques 16 et de leurs connectiques, afin de garantir la résistance au niveau très élevé de pression qui est appliqué à l'étape E3, ainsi que du calibrage de l'entrefer prédéterminé 26 du moule d'assemblage 20 pour éviter le déplacement et la casse des cellules 16 au contact des parties de moule 22, 24 tout en minimisant le fluage des éventuels matériaux d'encapsulation 181, 182 vers des points bas du moule résultant des conditions de chauffe, qui induirait l'obtention inévitable d'un module photovoltaïque ayant une épaisseur non homogène.

Le procédé de fabrication présente également comme avantage de pouvoir être mis en œuvre avec une résine de nature thermodurcissable ou avec une résine de nature thermoplastique.

En outre, l'utilisation du moule d'assemblage 20 ayant les deux parties de moule 22, 24 constituées dans un matériau avantageusement rigide et configuré pour adopter l'entrefer prédéterminé 26 permet de garantir la présence d'un entrefer ayant une valeur parfaitement répétable et indépendante de la pression mécanique F1 appliquée par le moule d'assemblage 20 sur le module photovoltaïque 10 et indépendamment de la pression du gaz présent dans la cavité 30. Ces dispositions garantissent une excellente répétabilité de l'étape E2 et une bonne fiabilité des modules photovoltaïques 10 fabriqués. L'utilisation d'un moule d'assemblage 20 conformément aux étapes E2 et E3 permet en outre de répondre aux problématiques de risque de fluage des matériaux d'encapsulation 181, 182 vers des points bas du moule.

Le procédé de fabrication qui vient d'être décrit permet avantageusement de réaliser des pièces complexes, conformés et avec des formes gauches, avec des courbures du module photovoltaïque 10 dans la limite de la tenue mécanique des cellules photovoltaïques 16, mais également une possibilité d'ajout d'inserts ou de bords rainurés ou présentant des formes complexes (raidisseurs, ...).

Le procédé de fabrication permet de s'affranchir de l'utilisation de faces avant et arrière en verre et/ou polymère non renforcé, et de remplacer cela respectivement par un premier matériau composite et par un deuxième matériau composite obtenu par l'étape E2 de moulage par transfert de résine exploitant, en une seule opération moyennant une injection à chaud et sous pression, une seule et même résine pour les première et deuxième couches 12, 14. Le module photovoltaïque 10 fabriqué peut posséder une masse surfacique par exemple entre 1 kg/m² et 8 kg/m², ou plus particulièrement entre 4 kg/m² et 6 kg/m², qui est largement inférieure à celle d'un module classique en verre qui est classiquement compris entre 10 et 12 kg/m².

Dans la variante où la première couche 12 à obtenir présente une forme gauche et où la deuxième couche 14 à obtenir présente aussi une forme gauche, la première empreinte 220 présente une première forme telle que la première couche 12 est conformée selon une première forme gauche à l'issue de l'étape E3 et la deuxième empreinte 240 présente une deuxième forme telle que la deuxième couche 14 est conformée spatialement selon une deuxième forme gauche à l'issue de l'étape E3.

Selon un mode de mise en œuvre particulier, l'étape E2 comprend, après l'étape E1, les étapes suivantes :
- une étape E21 de dépression appliquée à la cavité 30 délimitée par le moule d'assemblage 20 dans la configuration de fermeture, par rapport à la pression régnant à l'extérieur de la cavité 30,
- optionnellement, une étape E32 de chauffage de l'empilement initial 28,
- une étape E22 d'injection de la résine dans la cavité 30 de manière pressurisée à une pression strictement supérieure à la pression régnant dans la cavité 30.

Selon un mode de réalisation particulier, il est possible que le moule d'assemblage 20 soit chauffé lors de l'étape E2, par exemple à température constante avec un thermorégulateur à huile. Dans ce cas, l'étape E2 comprend l'étape E32 de chauffage de l'empilement initial 28 par la transmission de calories depuis le moule d'assemblage 20 vers l'empilement initial 28. Il est également possible qu'une telle étape E32 de chauffage soit consécutive à l'injection de la résine lors de l'étape E22. Dans ce cas, la résine injectée transmet des calories à l'empilement initial 28 pour mettre en œuvre l'étape E32 de chauffage.

Ainsi, il ne s'agit pas forcément d'étapes successives. L'étape E32 peut ainsi être mise en œuvre avant, pendant ou après l'étape E1. L'étape E22 est réalisée après l'étape E21.

Selon un mode de réalisation particulier, dans l'étape E21, la pression établie dans la cavité 30 est comprise entre 0,5.10⁵ Pa et 1.10⁵ Pa.

Selon un mode de réalisation, l'étape E32 consiste à chauffer la première partie de moule 22 et/ou la deuxième partie de moule 24.

Par exemple, pour la mise en œuvre de l'étape E32 la première partie de moule 22 et la deuxième partie de moule 24 peuvent être couplées mécaniquement et thermiquement à une presse chauffante, configurée pour pouvoir déplacer les parties de moule 22, 24 l'une par rapport à l'autre afin de pouvoir appliquer la pression mécanique F1, et pour pouvoir transmettre des calories de la presse chauffante aux parties de moule 22, 24 par conduction thermique ou par intégration de résistances chauffantes. De manière générale, il n'est pas forcément nécessaire de prévoir une presse chauffante, en ce sens que les moyens de chauffe peuvent être indifféremment internes ou externes aux outillages du moule d'assemblage 20.

En outre, comme cela est schématisé sur la figure 3, l'étape E2 peut comprendre optionnellement une étape E20 qui consiste à chauffer la résine préalablement à la mise en œuvre de l'étape E22. Notamment, l'étape E20 peut être réalisée d'une manière à atteindre après l'étape E20 (avant injection) une température garantissant que la température de la résine soit, au moment du contact entre la résine et l'au moins un matériau d'encapsulation 181, 182, strictement supérieure à une température à laquelle l'au moins un matériau d'encapsulation 181, 182 subit une fusion au moins partielle.

Dans le cas où la résine est thermoplastique, la température nécessaire à la mise en œuvre de l'étape E2 peut être proche de la température ambiante, inférieure à 100° C ou alternativement supérieure à 100°C, voire supérieure à 150°C et inférieure à 250°C, selon le type de résine utilisée. Dans le cas où la résine est thermodurcissable, la température nécessaire à la mise en œuvre de l'étape E3 est typiquement comprise entre 60°C et 130°C .

Parallèlement à cela, la température à laquelle l'au moins un matériau d'encapsulation 181, 182 subit une fusion au moins partielle est généralement comprise entre 60 et 180°C, préférentiellement entre 80°C et 150°C, cette température permettant l'intégration des cellules photovoltaïques 16 dans l'ensemble encapsulant 18. La température de cette mise en œuvre doit être soigneusement ajustée pour éviter autant que possible le fluage de l'ensemble encapsulant 18, favorisé par la possible forme gauche du module photovoltaïque 10. De même, l'entrefer 26 du moule d'assemblage 20 doit être ajusté avec précision pour ne pas endommager les cellules photovoltaïques 16.

Dans une première possibilité de mise en oeuvre, l'étape E20 est réalisée de sorte que la résine atteigne une température, avant son injection à l'étape E22, qui soit déjà supérieure à la température à laquelle l'au moins un matériau d'encapsulation 181, 182 subit une fusion au moins partielle. Alternativement, dans une deuxième possiblité de mise en œuvre, l'étape E20 est réalisée de sorte que la résine atteigne, avant son injection à l'étape E22, une température (par exemple de l'ordre de 50°C, correspondant à une sorte de préchauffage) qui soit strictement inférieure à la température à laquelle l'au moins un matériau d'encapsulation 181, 182 subit une fusion au moins partielle. Dans cette deuxième possibilité, c'est le fait de circuler dans la cavité 30 du moule d'assemblage 20 ayant été préalablement été chauffé, qui permet d'augmenter la température de la résine après son injection jusqu'à devenir supérieure à la température à laquelle l'au moins un matériau d'encapsulation 181, 182 subit une fusion au moins partielle.

Avantageusement, il est prévu que la température atteinte par l'empilement initial 28 à l'étape E32 soit maintenue durant tout ou partie de l'étape E22. Cela favorise la mise en œuvre du moulage par transfert de résine de manière homogène spatialement dans toute la cavité 30, et homogène dans le temps en évitant les variations de comportement de la résine qui seraient sinon induites par une baisse de la température au sein de l'empilement si l'on ne maintenait pas la température durant l'étape E22.

Selon un mode de réalisation particulier, durant l'étape E22, l'injection de la résine est réalisée de manière dirigée suivant une direction préférentielle suivant laquelle la résine circule préférentiellement à l'intérieur de la cavité 30 délimitée par le moule d'assemblage 20. Il convient par exemple de se référer aux flèches F6 sur les figures 6, 8 et 10.

En référence maintenant plus particulièrement à la figure 6 qui est une vue en coupe du moule d'assemblage 20, il peut être observé que le moule d'assemblage 20 comprend au moins une sortie d'évacuation 36 en connexion fluidique avec un système d'aspiration (non représenté) permettant d'établir une dépression dans la cavité 30 délimitée par le moule d'assemblage 20 et/ou au moins une entrée d'alimentation 32 en connexion fluidique avec un système d'alimentation permettant d'injecter la résine en direction de la cavité 30 délimitée par le moule d'assemblage 20.

Selon la variante illustrée sur la figure 6, à l'issue de l'étape E1, l'au moins une entrée d'alimentation 32 et l'au moins une sortie d'évacuation 36 sont situées de part et d'autre de l'empilement initial 28 selon une première direction D1. Cette première direction D1 est orientée suivant la direction préférentielle suivant laquelle la résine circule préférentiellement à l'intérieur de la cavité 30 délimitée par le moule d'assemblage 20.

Toujours en référence à la figure 6, le moule d'assemblage 20 peut comprendre préférentiellement au moins un premier média drainant 34 dans lequel débouche l'au moins une entrée d'alimentation 32 et/ou au moins un deuxième média drainant 38 dans lequel débouche l'au moins une sortie d'évacuation 36, chacun du premier média drainant 34 et du deuxième média drainant 38 assurant un drainage de la résine suivant une deuxième direction D2 orientée transversalement (par exemple de manière sensiblement orthogonale à 10° près) à la première direction D1.

La circulation au sein du premier média drainant 34 de la résine injectée par l'au moins une entrée d'alimentation 32 est symbolisée sur la figure 6 par les flèches F5. La circulation au sein du deuxième média drainant 38 de la résine qui va être aspirée l'au moins une sortie d'évacuation 36 est symbolisée sur la figure 6 par les flèches F7.

Le phénomène de dépression au niveau de l'au moins une sortie d'évacuation 36 est schématisé par la flèche F4 sur les figures 8 et 10, dans les phases P1 et P2. Le phénomène de l'injection de la résine au niveau de l'au moins une entrée d'alimentation 32 est schématisé par la flèche F3 sur les figures 8 et 10, dans la phase P2.

Par ces dispositions, on s'assure que la résine puisse passer, durant la mise en œuvre de l'étape E2 :
- à travers l'au moins un premier renfort sec le long de toute la longueur du module photovoltaïque 10 comptée suivant la première direction D1 et le long de toute la largeur du module photovoltaïque 10 comptée suivant la deuxième direction D2, et ce sur au moins la totalité de l'épaisseur recherchée pour la première couche 12,
- et à travers l'au moins un deuxième renfort sec le long de toute la longueur du module photovoltaïque 10 comptée suivant la première direction D1 et le long de toute la largeur du module photovoltaïque 10 comptée suivant la deuxième direction D2, et ce sur au moins la totalité de l'épaisseur recherchée pour la deuxième couche 14.

Alternativement et selon un mode de réalisation illustré par exemple sur la figure 5, dans lequel les premier et deuxième joints 222, 242 comprennent des évents atmosphériques 232, durant l'étape E2, lesdits évents atmosphériques 232 sont configurés pour laisser passer l'air. Dans ce cas, le moule d'assemblage 20 comprend au moins une entrée d'alimentation 32 en connexion fluidique avec un système d'alimentation, la fonction d'évacuation étant garantie par les évents atmosphériques 232. Un système d'aspiration n'est alors pas nécessaire.

Selon un mode de réalisation particulier, dans l'étape E22, l'injection de la résine est pilotée (en terme de débit, de pression de sortie etc.) de sorte que la pression régnant dans la cavité 30 délimitée par le moule d'assemblage 20 est comprise entre 2.10⁵ Pa et 50.10⁵ Pa. Comme déjà indiqué, cette valeur très élevée de la pression tout en s'affranchissant des risques connus de fluage des matériaux d'encapsulation dans les solutions existantes offre l'opportunité de conditions de pression et de température d'injection de la résine optimales pour la tenue mécanique du module photovoltaïque 10.

Il est possible d'envisager d'utiliser à l'étape E2 toute résine apte à être injectée à chaud et compatible avec une technique de moulage par transfert de résine, présentant une bonne adhésion sur le matériau encapsulant 181, 182 ou les cellules photovoltaïques 16. Pour la première face 12 du côté avant, la résine aura préférentiellement un indice de réfraction proche de celui du verre utilisé pour la composition de l'au moins un premier renfort sec utilisé (qui est de l'ordre de 1,51) pour offrir une bonne transparence.

La première partie de moule 22 et la deuxième partie de moule 24 du moule d'assemblage 20 exercent, sur l'empilement, une pression mécanique durant tout ou partie de l'étape E2, en particulier durant toutes les étapes E21, E32 (phase P1) et E22 (phase P2), et durant tout ou partie de l'étape E3 (phase P3). Ces dispositions sont illustrées par exemple sur les figures 8 et 10.

Cette pression mécanique, repérée par les flèches F1 sur les figures 8 et 10 durant les phases P1 à P3, peut être obtenue par le fait que le moule d'assemblage 20 soit associé à une presse apte à exercer cette pression mécanique F1, par exemple une presse chauffante adaptée en sus à la mise en température nécessaire à la mise en œuvre de l'étape E32. Par exemple, la première partie de moule 22 et la deuxième partie de moule 24 peuvent être couplées mécaniquement (et thermiquement) à une presse (chauffante) configurée pour pouvoir déplacer les parties de moule 22, 24 l'une par rapport à l'autre afin de pouvoir appliquer la pression mécanique F1.

Selon un mode de réalisation, la pression mécanique F1 est comprise entre 90.10⁵ Pa et 150.10⁵ Pa, et plus particulièrement égale à 90.10⁵ Pa, ou égale à 150.10⁵ Pa.

Enfin, comme cela est visible sur la figure 3, le procédé de fabrication comprend une étape E4 consistant à ouvrir le moule d'assemblage 20, afin que ce dernier passe de la configuration de fermeture à la configuration d'ouverture. L'étape E4 est mise en œuvre après l'étape E3. Ces dispositions correspondent aux phases P4 sur les figures 7 à 10. Cette étape E4 d'ouverture du moule d'assemblage 20 peut être mise en œuvre de différentes manières, notamment en fonction du type de résine utilisée.

Selon un premier mode de réalisation, la résine est une résine thermoplastique. Cela permet avantageusement de conférer un caractère fondamental au module photovoltaïque 10 : être une matière recyclable en fin de vie. Par ailleurs, une fois que le module photovoltaïque 10 a été fabriqué, il est éventuellement possible de rendre à nouveau la résine souple ou liquide en réalisant un nouvel apport de calories à la résine qui soit suffisant pour faire changer d'état la résine, permettant par exemple de rendre le module photovoltaïque 10 démontable plus aisément que dans le cas d'une résine thermodurcissable.

Par exemple la résine thermoplastique utilisée pour la première couche 12 peut être choisie parmi : le styrène-acrylonitrile (SAN), le polycarbonate (PC), le polystyrène (PS), le poly(méthacrylate de méthyle) (PMMA), le polyamide (PA), le polyfluorure de vinylidène (PVDF), l'éthylène tétrafluoroéthylène (ETFE), l'éthylene de chlorotrifluoroéthylène (ETCFE), le polyfluorure de vinyle (PVF), le Polytétrafluoroéthylène (PTFE), ou équivalents.

La résine thermoplastique utilisée pour la deuxième couche 14 peut être choisie parmi celles décrites ci-avant concernant la première couche 12, ou parmi : le polyéthylène (PE), le polypropylène (PP), le polyéthylène téréphtalate (PET), le polychlorure de vinyle (PVC), l'acrylonitrile-butadiène-styrène (ABS).

Il est donc bien compris que la résine thermoplastique utilisée lors de l'étape E2 peut être la même pour le premier matériau composite formant la première couche 12, et pour le deuxième matériau composite formant la deuxième couche 14.

Toujours dans ce premier mode de réalisation où la résine est une résine thermoplastique, la température à atteindre au sein de l'empilement initial 28 durant l'étape E32, est comprise entre 15°C et 260°C

Toujours durant le premier mode de réalisation où la résine est une résine thermoplastique, l'étape E3 comprend une étape d'abaissement de la température de l'empilement issu de l'étape E2 par rapport aux conditions présentes durant l'étape E2. Ces dispositions sont visibles sur les figures 7 et 8.

Selon une première variante, l'étape E3 est mise en œuvre par l'ouverture du moule d'assemblage 20 conduisant à un refroidissement de l'empilement issu de l'étape E32 par convection naturelle. Cette première variante est adaptée davantage aux résines thermodurcissables qui présentent l'avantage de ne pas ou peu subir de phénomène de retrait lors du refroidissement.

Selon une deuxième variante, l'étape E3 comprend une étape de refroidissement mise en œuvre dans un moule de refroidissement distinct du moule d'assemblage 20. Il est ainsi possible de limiter les phénomènes de retrait. Une telle variante est adaptée à la fois pour le refroidissement de résines thermodurcissables, mais également pour les résines thermoplastiques.

En support du mode de réalisation où la résine injectée à l'étape E2 est une résine thermoplastique, la figure 7 représente une première courbe illustrant un exemple d'évolution, avec différentes phases P1 à P4 successives, de la température adoptée par le moule d'assemblage 20 en fonction du temps dans le procédé de fabrication exploitant une résine thermoplastique, tandis que la figure 8 représente schématiquement le comportement du moule d'assemblage 20 et de l'empilement durant une première phase P0 initiale puis durant les différentes phases P1 à P4 correspondant à celles définies sur la figure 7.

Les figures 7 et 8 font référence à différentes situations successives d'un exemple de procédé de fabrication mettant en œuvre les enseignements généraux présentés ci-avant, avec cinq phases successives P0 à P4.

Ces phases successives P0 à P4 sont notamment appliquées dans le but de fabriquer un module photovoltaïque 10 présentant une forme plane sans que cela ne soit limitatif, et comprenant (ces éléments ne sont pas illustrés en détail sur les figures 7 et 8) :
- une première couche 12 ayant une forme plane, formée dans le premier matériau composite, transparente et destinée à former la face avant du module photovoltaïque 10, laquelle est destinée à recevoir un flux lumineux,
- une deuxième couche 14 ayant une forme plane, formée dans un deuxième matériau composite, et destinée à former une face arrière du module photovoltaïque 10,
- une pluralité de cellules photovoltaïques 16 disposées côte à côte, reliées électriquement entre elles et situées entre la première couche 12 et la deuxième couche 14,
- un ensemble encapsulant 18 assurant une encapsulation de tout ou partie des cellules photovoltaïques 16.

Dans une première phase P0, il est procédé à la formation de l'empilement initial 28 où l'empilement initial 28 comprend successivement les éléments suivants superposés, en allant de la face avant vers la face arrière du module photovoltaïque 10 :
- au moins un premier renfort sec (par exemple au nombre de trois) destiné à appartenir à la première couche 12 et à entrer dans la composition du premier matériau composite,
- un premier matériau d'encapsulation 181 disposé entre le premier renfort sec et les cellules photovoltaïques 16,
- la pluralité de cellules photovoltaïques 16, où ces cellules photovoltaïques sont déjà interconnectées entre elles,
- un deuxième matériau d'encapsulation 182 disposé entre le deuxième renfort sec et les cellules photovoltaïques 16,
- au moins un deuxième renfort sec (par exemple au nombre de trois) destiné à appartenir à la deuxième couche 14 et à entrer dans la composition du deuxième matériau composite.

Cette opération peut être réalisée manuellement ou au moyen de robots de manipulation ou de manière semi-automatique. Au sein de l'empilement initial 28, la pluralité de cellules photovoltaïques 16 est située entre l'au moins un premier renfort sec et l'au moins un deuxième renfort sec, et chacun des matériaux d'encapsulation 181, 182 est situé entre l'au moins un premier renfort sec et l'au moins un deuxième renfort sec également.

La notion de « premier » et « deuxième » matériaux d'encapsulation 181, 182 n'a pour vocation que de les distinguer d'un point de vue de leur positionnement différent au sein de l'empilement initial 28. Ces deux matériaux d'encapsulation 181, 182, certes positionnés à des emplacements différents, peuvent éventuellement être de même nature tant dans la composition que l'épaisseur ou le nombre de couches. D'ailleurs il est possible que les deux matériaux d'encapsulation 181, 182 soient formés soit en deux plis différents et indépendants, soit en un seul et même pli formant un ensemble unitaire.

Puis dans une deuxième phase P1, il est procédé d'abord à ce qui correspond à l'étape E1 de mise en place de l'empilement initial 28 dans le moule d'assemblage 20, adoptant initialement la configuration d'ouverture pour pouvoir accéder à l'intérieur de la cavité 30 et y déposer l'empilement initial 28. Cette opération peut être réalisée manuellement ou au moyen de robots de manipulation ou de manière semi-automatique.

Ensuite, toujours dans la deuxième phase P1, on passe le moule d'assemblage 20 de la configuration d'ouverture à la configuration de fermeture, la première partie de moule 22 et la deuxième partie de moule 24 étant alors séparées par l'entrefer prédéterminé 26 qui est strictement supérieur à l'épaisseur de l'empilement initial 28. La cavité 30 fermée renferme de manière étanche l'empilement initial 28.

Toujours durant la deuxième phase P1, il est procédé à l'étape E32 de chauffage du moule d'assemblage 20 et à l'étape E21 de dépression appliquée à la cavité 30 à partir de la pression régnant à l'extérieur de la cavité 30, ces étapes pouvant être mises en œuvre dans un ordre indifférent et possiblement avec un chevauchement temporel entre elles.

Il en résulte d'abord une augmentation de la température de l'empilement initial 28. C'est la raison pour laquelle, dans la phase P1, la courbe illustrée sur la figure 7 (laquelle représente l'évolution de la température (en ordonnées) de l'empilement initial 28 en fonction du temps (en abscisses)) se présente sous la forme d'un profil croissant dans le temps, par exemple de manière rectiligne. A titre d'exemple pour réaliser ce chauffage selon l'étape E32, le moule d'assemblage 20 est placé à une température constante, par exemple de 100°C, impliquant une augmentation de la température de l'empilement initial 28. Il est en tous cas prévu que la température nominale soit strictement supérieure à la température fonctionnelle à laquelle l'au moins un matériau d'encapsulation 181, 182 subit une fusion au moins partielle (la température fonctionnelle étant généralement comprise entre 70 et 180°C, préférentiellement entre 80°C et 150°C).

L'apport de chaleur à l'empilement initial 28 dû au phénomène de chauffe du moule d'assemblage 20 est schématisé par les flèches F0.

Alternativement, l'empilement initial 28 pourrait avoir été réalisé simultanément au chauffage du moule d'assemblage 20, permettant un gain de temps, l'empilement initial 28 étant alors déposé dans le moule d'assemblage 20 déjà chaud.

Il est rappelé qu'il n'est pas forcément nécessaire de prévoir une presse chauffante, en ce sens que les moyens de chauffe peuvent être indifféremment internes ou externes aux outillages du moule d'assemblage 20.

Dans la deuxième phase P1, la mise en œuvre de l'étape E21 peut consister à établir une dépression au niveau de l'au moins une sortie d'évacuation 36 en faisant fonctionner le système d'aspiration (lequel peut être équipé d'une pompe, d'un filtre et être configuré pour pouvoir aspirer tant les gaz présents dans la cavité 30 que de la résine précédemment injectée dans la cavité). Durant l'étape E21, la résine n'est pas injectée par l'au moins une entrée d'alimentation 32. La flèche F4 symbolise l'extraction des gaz par l'effet de dépression et il en résulte donc la mise en place de conditions de pression proche du vide au sein de la cavité 30 à la fin de l'étape E21. Cela permettra la mise en œuvre de l'étape E2 ultérieure de moulage par transfert de résine.

Toujours dans la deuxième phase P1, le moule d'assemblage 20 exerce la pression mécanique (par exemple d'environ 5.10⁵ Pa), schématisée par les flèches F1, ce qui implique une compression de l'empilement présent dans la cavité 30 du moule d'assemblage 20.

Puis une troisième phase P2 débute, laquelle correspond concrètement à la mise en œuvre de l'étape E22 d'injection de la résine dans la cavité 30 de manière pressurisée à une pression strictement supérieure à la pression régnant dans la cavité 30.

La mise en œuvre de l'étape E22 d'injection de la résine peut consister à établir une dépression au niveau de l'au moins une sortie d'évacuation 36 en faisant fonctionner le système d'aspiration et/ou à établir une surpression au niveau de l'au moins une entrée d'alimentation 32 en faisant fonctionner le système d'alimentation. Durant l'étape E22, la résine est injectée par l'au moins une entrée d'alimentation 32, ce qui est symbolisé par la flèche notée F3 dans la phase P2 de la figure 8, tandis que dans le même temps l'extraction des gaz par l'effet de dépression au niveau de l'au moins une sortie d'évacuation 36 est prolongée, ce qui est symbolisé par la flèche F4 dans la phase P2 de la figure 8.

Il en résulte alors une augmentation de la pression au sein de la cavité 30 et au sein de l'empilement présent dans la cavité 30, durant le moulage par transfert de résine. Cela impose un compactage à haute pression des différentes couches et composants du module photovoltaïque 10, ce qui est important pour les propriétés mécaniques élevées obtenues.

Préalablement à l'injection, la résine subit un chauffage conformément à l'étape E20, permettant :
- soit de garantir que la résine présente, dès son injection, une température supérieure à la température fonctionnelle au-delà de laquelle chaque matériau d'encapsulation 181, 182 subit une fusion au moins partielle sous l'effet de calories transmises par la résine,
- soit de garantir que la résine présente, au moment de son injection, une température strictement inférieure à la température fonctionnelle mais susceptible d'augmenter (sous l'effet des calories transmises à la résine par le moule d'assemblage 20 durant l'étape E2 ; flèches F1) durant la circulation de la résine au sein de la cavité 30 d'une manière suffisante pour devenir strictement supérieure à la température fonctionnelle.

La circulation suivant la deuxième direction D2 au sein du premier média drainant 34 de la résine précédemment injectée au niveau de l'au moins une entrée d'alimentation 32 est symbolisée sur la figure 6 par les flèches F5. La circulation dirigée suivant la première direction D1, dans un sens allant du premier média drainant 34 vers le deuxième média drainant 38, en particulier au sein de l'empilement en cours d'imprégnation par la résine qui circule, est symbolisée par les flèches F6 tant sur la figure 8 que sur la figure 6. La circulation suivant la deuxième direction D2, au sein du deuxième média drainant 38, de la résine qui va être aspirée par l'au moins une sortie d'évacuation 36 est symbolisée sur la figure 6 par les flèches F7.

Par ces dispositions, on s'assure que la résine, chaude et sous pression, passe de manière homogène spatialement :
- à travers l'au moins un premier renfort sec le long de toute la longueur du module photovoltaïque 10 comptée suivant la première direction D1 et le long de toute la largeur du module photovoltaïque 10 comptée suivant la deuxième direction D2, et ce sur au moins la totalité de l'épaisseur recherchée pour la première couche 12,
- et à travers l'au moins un deuxième renfort sec le long de toute la longueur du module photovoltaïque 10 comptée suivant la première direction D1 et le long de toute la largeur du module photovoltaïque 10 comptée suivant la deuxième direction D2, et ce sur au moins la totalité de l'épaisseur recherchée pour la deuxième couche 14.

La température atteinte par l'empilement initial 28 à l'étape E32 (à la fin de la deuxième phase P1) est maintenue durant tout ou partie de l'étape E22, préférentiellement jusqu'à la fin de l'étape E22, donc jusqu'à la fin de la troisième phase P2. C'est la raison pour laquelle, dans la troisième phase P2, la courbe illustrée sur la figure 7 se présente sous la forme d'un profil constant dans le temps. Cela favorise la mise en œuvre du moulage par transfert de résine de manière homogène spatialement dans toute la cavité 30, et homogène dans le temps en évitant les variations de comportement de la résine qui seraient sinon induites par une baisse de la température au sein de l'empilement si l'on ne maintenait pas la température durant l'étape E22. Durant toute la troisième phase P2, le moule d'assemblage 20 est maintenu en température à la température nominale et continue de chauffer l'empilement et la résine injectée, d'où la présence des flèches F0 dans la troisième phase P2 sur la figure 8.

Dans les conditions de pression et de température élevées, la résine à l'état liquide vient remplir et comble les volumes suivants durant la troisième phase P2 :
- tout le volume présent spatialement entre l'au moins un premier renfort sec et le matériau d'encapsulation 181 agencé du côté de l'au moins un premier renfort sec,
- tout le volume qui correspond à la première couche 12,
- tout le volume présent spatialement entre l'au moins un deuxième renfort sec et le matériau d'encapsulation 182 agencé du côté de l'au moins un deuxième renfort sec,
- tout le volume qui correspond à la deuxième couche 14.

Dans cette troisième phase P2, du fait que la température de la résine en cours de transfert pour le moulage RTM est supérieure à la température fonctionnelle à partir de laquelle les matériaux d'encapsulation 181, 182 subissent une fusion au moins partielle, les deux matériaux d'encapsulation 181, 182 subissent une fusion sous l'effet des calories transmises par la résine, permettant de convertir les matériaux d'encapsulation 181, 182 en un ensemble encapsulant 18 adhérant d'une part à la pluralité de cellules photovoltaïques 16 et d'autre part à la première couche 12 et/ou à la deuxième couche 14. L'organisation des matériaux d'encapsulation 181, 182 et la manière d'assurer leur fusion sont adaptées de sorte que l'ensemble encapsulant 18 qui résulte de cette fusion au moins partielle assure une encapsulation de tout ou partie des cellules photovoltaïques 16. Il est notamment possible d'obtenir un ensemble encapsulant 18 qui englobe toutes les cellules photovoltaïques 16 de manière hermétique et étanche à l'eau.

Dans le procédé de fabrication décrit ici, il est important de comprendre qu'il est utilisé une seule résine entrant dans la composition des deux matériaux composites dans lesquels respectivement la première couche 12 et la deuxième couche 14 sont formées, et que cette résine, injectée à l'étape E2 de moulage par transfert de résine, remplit non seulement la fonction de consolider ces deux matériaux composites (en combinaison avec l'au moins un premier renfort sec pour finaliser la première couche 12 et en combinaison avec l'au moins un deuxième renfort sec pour finaliser la deuxième couche 14) mais aussi la fonction d'assurer à elle seule l'adhérence des différentes couches de l'empilement du module photovoltaïque 10 entre elles, typiquement par le fait que c'est cette résine chauffée d'une manière suffisante qui assure, au moment de l'étape E2, la fusion au moins partielle de l'au moins un matériau d'encapsulation 181, 182.

Puis, dans une quatrième phase P3, il est procédé à ce qui correspond à l'étape E4 de durcissement de la résine précédemment injectée. Dans le cas de la résine thermoplastique, ce durcissement se pratique par une polymérisation. C'est la raison pour laquelle il est généralement procédé à une diminution de la température du moule d'assemblage 20 et de l'empilement, et c'est la raison pour laquelle, dans la phase P3, la courbe illustrée sur la figure 7 se présente sous la forme d'un profil décroissant dans le temps, par exemple de manière rectiligne. A titre d'exemple, la température du moule d'assemblage 20 diminue à une vitesse de 8°C/min, jusqu'à atteindre la température initiale du début de la phase P0. Le transfert de chaleur du module photovoltaïque 10 vers le moule d'assemblage 20 est schématisé par les flèches F2. En outre, durant toute la quatrième phase P3, la pression mécanique (flèche F1) continue d'être exercée par le moule d'assemblage 20. La pression mécanique appliquée alors que les deux parties de moule 22, 24 du moule d'assemblage 20 subissent la diminution de température peut être égale à la pression mécanique F1 exercée durant les phases P1 et P2 décrites précédemment (c'est la raison pour laquelle dans la phase P3 sur la figure 8 la pression mécanique est schématisée par les mêmes flèches F1 que durant les phases P1 et P2), mais elle pourrait être différente en fonction des besoins.

Le fait de conserver le moule d'assemblage 20 dans la configuration de fermeture et de continuer à appliquer la pression mécanique F1 durant l'étape E3 de durcissement de la résine permet de conserver au mieux la forme du module photovoltaïque 10 et de limiter les risques de déformations indésirables sous l'effet du refroidissement et du durcissement.

Enfin, en référence à la figure 8, la cinquième phase P4 peut ensuite débuter, correspondant à la mise en œuvre de l'étape E4 d'ouverture du moule d'assemblage 20, dans laquelle le moule d'assemblage 20 passe de la configuration de fermeture à la configuration d'ouverture. L'étape E4 est mise en œuvre après l'étape E3. Durant la cinquième phase P4, les deux parties de moule 22, 24 subissent un éloignement relatif par translation et/ou rotation, jusqu'à être distant l'un de l'autre d'une distance strictement supérieure à la valeur de l'entrefer prédéterminé 26. Dans cet éloignement relatif des parties de moule 22, 24, le moule d'assemblage 20 libère la pression mécanique F1 précédemment exercée et le module photovoltaïque 10 reste dans la forme précédemment obtenue, à un potentiel phénomène de retour élastique près.

Selon un deuxième mode de réalisation particulier, la résine est une résine thermodurcissable. Par exemple, la résine thermodurcissable transparente utilisée pour la première couche 12 est une résine époxy, une résine polyuréthane (PUR), ou une silicone. Dans le cas de la deuxième couche 14, la résine utilisée peut être choisie parmi les résines transparentes (résine époxy, résine PUR, ou un silicone). Il est donc bien compris que la résine thermodurcissable utilisée lors de l'étape E2 peut être la même pour le premier matériau composite formant la première couche 12, et pour le deuxième matériau composite formant la deuxième couche 14. Un avantage de l'utilisation d'une résine thermodurcissable est, pour de nombreuses applications, de conférer une excellente résistance mécanique au module photovoltaïque 10 fabriqué.

Toujours dans ce deuxième mode de réalisation où la résine est une résine thermodurcissable, la température à atteindre au sein de l'empilement initial 28 durant l'étape E32 est comprise entre 90°C et 130°C.

Toujours dans ce deuxième mode de réalisation où la résine est une résine thermodurcissable, l'étape E3 comprend une étape de maintien ou d'augmentation de la température de l'empilement issu de l'étape E2 par rapport aux conditions présentes durant l'étape E2. Ces dispositions sont visibles sur les figures 9 et 10. Selon un mode de réalisation, l'étape de maintien est mise en œuvre pendant une durée supérieure à 1 min et inférieure à 1h, ladite durée étant dépendant de la résine utilisée.

En support de ce deuxième mode de réalisation où la résine est une résine thermodurcissable, la figure 9 représente une deuxième courbe illustrant un exemple d'évolution, avec différentes phases P1 à P4 successives, de la température adoptée par le moule d'assemblage 20 en fonction du temps dans le procédé de fabrication exploitant une résine thermodurcissable, tandis que la figure 10 représente schématiquement le comportement du moule d'assemblage 20 et de l'empilement durant une première phase P0 initiale puis durant les différentes phases P1 à P4 correspondant à celles définies sur la figure 9.

Les figures 9 et 10 font référence à différentes situations successives d'un exemple de procédé de fabrication mettant en œuvre les enseignements généraux présentés ci-avant, avec cinq phases successives P0 à P4, dans le cas particulier où la résine est thermodurcissable.

Les principes des différentes phases P0 à P4 du présent exemple utilisant une résine thermodurcissable sont globalement similaires aux principes des phases P0 à P4 déjà décrites de l'exemple utilisant une résine thermoplastique, à certaines différences techniques près induites justement par le remplacement de la résine thermoplastique par une résine thermodurcissable. Ainsi, tous ces principes ne seront pas à nouveau décrits ici pour éviter une longueur inutile du texte, s'attachant uniquement à exposer ces différences techniques.

De la même manière que pour le procédé décrit en lien avec les figures 7 et 8, il peut être utilisé une matrice thermodurcissable pour fabriquer un module photovoltaïque 10 de forme plane ou de forme gauche, et intégrant ou non l'au moins un matériau d'encapsulation 181, 182.

La première phase P0 du procédé des figures 9 et 10 est réalisée de manière identique à ce qui a été décrit en lien avec les figures 7 et 8.

Puis dans la deuxième phase P1 du procédé des figures 9 et 10, les étapes E1, E21 et E32 sont mises en œuvre, comme précédemment.

Par contre, contrairement aux dispositions précédemment décrites dans le cas de l'utilisation d'une résine thermoplastique, la température nominale atteinte par l'empilement initial 28 à la fin de l'étape E32 peut être comprise entre 90°C et 130°C dans le cas où la résine utilisée ensuite est de type thermodurcissable. Dans tous les cas et comme précédemment, il est pris soin que la température nominale soit supérieure ou égale à la température fonctionnelle à laquelle l'au moins un matériau d'encapsulation 181, 182 subit une fusion au moins partielle.

Puis la troisième phase P2 est mise en œuvre, en reprenant les principes déjà décrits pour la phase P2 en lien avec les figures 7 et 8, sauf en ce qui concerne la valeur de la température de la résine durant l'étape E22. Dans le cas d'une résine thermodurcissable, la température de mise en œuvre de la résine afin de réaliser le moulage par transfert de résine durant l'étape E22 est potentiellement moins élevée que dans le cas d'une résine thermoplastique.

Puis, dans la quatrième phase P3 des figures 9 et 10, il est procédé à ce qui correspond à l'étape E3 de durcissement de la résine précédemment injectée. Dans le cas d'une résine thermodurcissable, ce durcissement se pratique non pas par polymérisation, mais par une réticulation. C'est la raison pour laquelle il est procédé à un maintien ou à une augmentation de la température du moule d'assemblage 20 durant la quatrième phase P3, et c'est la raison pour laquelle, dans la phase P3, la courbe illustrée sur la figure 9 se présente sous la forme d'un profil constant dans le temps de manière rectiligne (bien que ce profil pourrait être légèrement croissant dans le temps, éventuellement). Contrairement au cas de la figure 8 où des flèches F2 étaient présentes, il est indiqué sur la figure 10, pour la quatrième phase P3, un transfert de chaleur du moule d'assemblage 20 vers le module photovoltaïque 10 (ce transfert de chaleur se faisant donc dans un sens inverse au cas déjà décrit où une résine thermoplastique était utilisée) schématisé par les flèches F0, de la même manière que dans les phases P1 et P2 du même procédé. En outre, comme dans le cas de la figure 8, la pression mécanique (flèche F1) continue d'être exercée par le moule d'assemblage 20 durant toute la quatrième phase P3. La pression mécanique qui est appliquée alors que les deux parties de moule 22, 24 du moule d'assemblage 20 sont maintenues en température à la température nominale ou subissent une augmentation de température, peut être égale à la pression mécanique F1 exercée durant les phases P1 et P2 ou être différente en fonction des besoins.

Enfin, en référence à la figure 10, la cinquième phase P4 peut ensuite débuter, cette phase P4 correspondant à la mise en œuvre de l'étape E4 d'ouverture du moule d'assemblage 20, dans laquelle le moule d'assemblage 20 passe de la configuration de fermeture à la configuration d'ouverture. Contrairement aux dispositions décrites précédemment en lien avec les figures 7 et 8 dans le cas de l'utilisation d'une résine thermoplastique, l'utilisation d'une résine thermodurcissable implique, comme cela est représenté sur la figure 9, qu'il soit procédé à une diminution de la température du moule d'assemblage 20 et de l'empilement durant la cinquième phase P4. C'est la raison pour laquelle, dans la cinquième phase P4, la courbe illustrée sur la figure 9 se présente sous la forme d'un profil décroissant dans le temps, par exemple de manière rectiligne.

Durant la cinquième phase P4, les deux parties de moule 22, 24 subissent non seulement la diminution de température évoquée au paragraphe précédent, mais aussi un éloignement relatif par translation et/ou rotation, jusqu'à être distant l'un de l'autre d'une distance strictement supérieure à la valeur de l'entrefer prédéterminé 26. Dans cet éloignement relatif des parties de moule 22, 24, le moule d'assemblage 20 libère la pression mécanique F1 précédemment exercée et le module photovoltaïque 10 reste dans la forme précédemment obtenue, à un potentiel phénomène de retour élastique près.

### NOMENCLATURE

1 : module photovoltaïque (état de la technique)
2 : face avant (état de la technique)
3 : ensemble encapsulant (état de la technique)
3a : couche avant (état de la technique)
3b : couche arrière (état de la technique)
4 : cellules photovoltaïques (état de la technique)
4a : face avant des cellules (état de la technique)
4b : face arrière des cellules (état de la technique)
5 : face arrière (état de la technique)
6 : conducteurs de liaison (état de la technique)
7 : boite de jonction (état de la technique)
10 : module photovoltaïque
12 : première couche
14 : deuxième couche
16 cellules photovoltaïques
18 : ensemble encapsulant
181 : matériau d'encapsulation
182 : matériau d'encapsulation
20 moule d'assemblage
22 : première partie de moule
220 : première empreinte du moule d'assemblage
222 : premier joint
232 : évents atmosphériques
24 : deuxième partie de moule
240 : deuxième empreinte du moule d'assemblage
242 : deuxième joint
26 : entrefer prédéterminé
28 : empilement initial
30 : cavité
32 : entrée d'alimentation
34 : première matrice drainante
36 : sortie d'évacuation
38 : deuxième matrice drainante
P0 : première phase
P1 : deuxième phase
P2 : troisième phase
P3 : quatrième phase
P4 : cinquième phase
E1 : étape de mise en place de l'empilement initial dans un moule d'assemblage
E2 : étape de moulage par transfert de résine
E3 : étape de durcissement de la résine injectée
E4 : étape d'ouverture du moule d'assemblage
E20 : étape de chauffage de la résine
E21 : étape d'abaissement de la pression régnant dans la cavité
E32 : étape de chauffage de l'empilement initial
E22 : étape d'injection de la résine dans la cavité
F0 : l'apport de chaleur à l'empilement
F1 : pression mécanique
F2 : transfert de chaleur du module photovoltaïque vers le moule d'assemblage
F3 : injection de résine
F4 : dépression d'air
F5 : écoulement de la résine dans le premier média drainant
F6 : écoulement de la résine dans la cavité et dans l'empilement
F7 : écoulement de la résine dans le deuxième média drainant
D1 : première direction
D2 : deuxième direction

## Revendications

1. Procédé de fabrication d'un module photovoltaïque (10) où le module photovoltaïque (10) comprend :
- une première couche (12) formée dans un premier matériau composite, transparente, destinée à former une face avant du module photovoltaïque (10) et à recevoir un flux lumineux,
- une deuxième couche (14) formée dans un deuxième matériau composite et destinée à former une face arrière du module photovoltaïque (10),
- et au moins une cellule photovoltaïque (16) située entre la première couche (12) et la deuxième couche (14),
le procédé de fabrication comprenant les étapes suivantes :
E1) mise en place d'un empilement initial (28) dans un moule d'assemblage (20), où l'empilement initial (28) comprend la superposition des éléments suivants :
- au moins un premier renfort sec destiné à appartenir à la première couche (12) et à entrer dans la composition du premier matériau composite,
- ladite au moins une cellule photovoltaïque (16),
- au moins un deuxième renfort sec destiné à appartenir à la deuxième couche (14) et à entrer dans la composition du deuxième matériau composite, et
- au moins un matériau d'encapsulation (181, 182), l'empilement initial (28) étant tel que ladite au moins une cellule photovoltaïque (16) est située entre
l'au moins un premier renfort sec et l'au moins un deuxième renfort sec, et étant tel que l'au moins un matériau d'encapsulation (181, 182) est situé entre l'au moins un premier renfort sec et l'au moins un deuxième renfort sec,
le moule d'assemblage (20) ayant une aptitude à varier entre une configuration d'ouverture et une configuration de fermeture et comprenant une première partie de moule (22) rigide délimitant une première empreinte (220) ayant une forme complémentaire de la forme de la première couche (12) et une deuxième partie de moule (24) rigide délimitant une deuxième empreinte (240) ayant une forme complémentaire de la forme de la deuxième couche (14), la première partie de moule (22) et la deuxième partie de moule (24) étant telles que, dans la configuration de fermeture du moule d'assemblage (20), la première partie de moule (22) et la deuxième partie de moule (24) sont espacées d'un entrefer prédéterminé (26) préférentiellement supérieur ou égal à l'épaisseur de l'empilement initial (28), et délimitent entre elles une cavité (30) fermée apte à recevoir l'empilement initial (28),
E2) moulage par transfert de résine, dans laquelle une résine à l'état liquide est injectée dans la cavité (30) d'une manière telle que la résine passe à travers l'au moins un premier renfort sec et à travers l'au moins un deuxième renfort sec, la température de la résine étant adaptée en fonction de l'au moins un matériau d'encapsulation (181, 182) pour que l'au moins un matériau d'encapsulation (181, 182) subisse une fusion au moins partielle sous l'effet de calories transmises par la résine et pour convertir l'au moins un matériau d'encapsulation (181, 182) en un ensemble encapsulant (18) adhérant d'une part à l'au moins une cellule photovoltaïque (16) et d'autre part à la première couche (12) et/ou à la deuxième couche (14), E3) durcissement de la résine injectée à l'étape E2, l'étape E3 étant réalisée par un ajustement adapté de la température régnant dans la cavité (30), en fonction de la nature de la résine, la combinaison de l'au moins un premier renfort sec et de la résine à l'état durcie à l'issue de l'étape E3 constituant ledit premier matériau composite et la combinaison de l'au moins un deuxième renfort sec et de la résine à l'état durcie à l'issue de l'étape E3 constituant ledit deuxième matériau composite.

2. Procédé de fabrication selon la revendication 1, dans lequel la première empreinte (220) présente une première forme telle que la première couche (12) est conformée selon une première forme gauche à l'issue de l'étape E3 et la deuxième empreinte (240) présente une deuxième forme telle que la deuxième couche (14) est conformée spatialement selon une deuxième forme gauche à l'issue de l'étape E3.

3. Procédé de fabrication selon l'une quelconque des revendications 1 ou 2, dans lequel l'étape E2 comprend, après l'étape E1, les étapes suivantes :
- E21) dépression appliquée à la cavité (30) délimitée par le moule d'assemblage (20) dans la configuration de fermeture, par rapport à la pression régnant à l'extérieur de la cavité (30),
- E22) injection de la résine dans la cavité (30) de manière pressurisée à une pression strictement supérieure à la pression régnant dans la cavité (30), l'étape E22 étant réalisée après l'étape E21.

4. Procédé de fabrication selon la revendication 3, dans lequel l'étape E2 comprend une étape E20 de chauffage de la résine réalisée préalablement à la mise en oeuvre de l'étape E22.

5. Procédé de fabrication selon l'une quelconque des revendications 3 ou 4, dans lequel dans l'étape E22, l'injection de la résine est réalisée de manière dirigée suivant une direction préférentielle suivant laquelle la résine circule préférentiellement à l'intérieur de la cavité (30) délimitée par le moule d'assemblage (20), et dans lequel le moule d'assemblage (20) comprend au moins une sortie d'évacuation (36) en connexion fluidique avec un système d'aspiration permettant d'établir une dépression dans la cavité (30) délimitée par le moule d'assemblage (20).

6. Procédé de fabrication selon la revendication 5, dans lequel le moule d'assemblage (20) comprend au moins une entrée d'alimentation (32) en connexion fluidique avec un système d'alimentation permettant d'injecter la résine en direction de la cavité (30) délimitée par le moule d'assemblage (20).

7. Procédé de fabrication selon la revendication 6, dans lequel à l'issue de l'étape E1, l'au moins une entrée d'alimentation (32) et l'au moins une sortie d'évacuation (36) sont situées de part et d'autre de l'empilement initial (28) selon une première direction (D1) orientée suivant ladite direction préférentielle, et dans lequel le moule d'assemblage (20) comprend au moins un premier média drainant (34) dans lequel débouche l'au moins une entrée d'alimentation (32), ledit premier média drainant (34) assurant un drainage de la résine suivant une deuxième direction (D2) orientée transversalement à la première direction (D1).

8. Procédé de fabrication selon la revendication 7, dans lequel le moule d'assemblage comprend au moins un deuxième média drainant (38) dans lequel débouche l'au moins une sortie d'évacuation (36), ledit deuxième média drainant (38) assurant un drainage de la résine suivant une deuxième direction (D2) orientée transversalement à la première direction (D1).

9. Procédé de fabrication selon l'une quelconque des revendications 3 à 8, dans lequel dans l'étape E21, la pression établie dans la cavité (30) est comprise entre 0,5.10⁵ Pa et 1.10⁵ Pa.

10. Procédé de fabrication selon l'une quelconque des revendications 3 à 9, dans lequel durant l'étape E22, l'injection de la résine est pilotée de sorte que la pression régnant dans la cavité (30) délimitée par le moule d'assemblage (20) est comprise entre 2.10⁵ Pa et 50.10⁵ Pa.

11. Procédé de fabrication selon l'une quelconque des revendications 1 à 10, dans lequel la résine est une résine thermoplastique, et dans lequel l'étape E3 comprend une étape d'abaissement de la température de l'empilement issu de l'étape E2 par rapport aux conditions présentes durant l'étape E2.

12. Procédé de fabrication selon l'une quelconque des revendications 1 à 11, dans lequel la résine est une résine thermodurcissable, et dans lequel l'étape E3 comprend une étape de maintien ou d'augmentation de la température de l'empilement issu de l'étape E2 par rapport aux conditions présentes durant l'étape E2.

13. Procédé de fabrication selon l'une quelconque des revendications 1 à 12, dans lequel la première partie de moule (22) et la deuxième partie de moule (24) du moule d'assemblage (20) exercent, sur l'empilement, une pression mécanique (F1) durant tout ou partie de l'étape E2 et durant tout ou partie de l'étape E3, dans lequel la pression mécanique (F1) est avantageusement comprise entre 90.10⁵ Pa et 150.10⁵ Pa, et plus particulièrement égale à 90.10⁵ Pa, ou égale à 150.10⁵ Pa.

14. Procédé de fabrication selon l'une quelconque des revendications 1 à 13, comprenant une étape E4 d'ouverture du moule d'assemblage (20) dans laquelle le moule d'assemblage (20) passe de la configuration de fermeture à la configuration d'ouverture, l'étape E4 étant mise en oeuvre après l'étape E3.

15. Procédé de fabrication selon l'une quelconque des revendications 1 à 14 dans lequel lors de l'étape E1, l'empilement initial (28) comprend en outre la superposition d'une boîte de jonction (7) destinée à recevoir un câblage nécessaire à l'exploitation du module photovoltaïque (1).

## Patentansprüche

1. Verfahren zur Herstellung eines Photovoltaikmoduls (10), wobei das Photovoltaikmodul (10) umfasst:
- eine erste Schicht (12), die aus einem ersten, transparenten Verbundmaterial gebildet ist, das dazu bestimmt ist, eine Vorderseite des Photovoltaikmoduls (10) zu bilden und einen Lichtstrom aufzunehmen,
- eine zweite Schicht (14), die aus einem zweiten Verbundmaterial gebildet ist und dazu bestimmt ist, eine Rückseite des Photovoltaikmoduls (10) zu bilden,
- und mindestens eine Photovoltaikzelle (16), die sich zwischen der ersten Schicht (12) und der zweiten Schicht (14) befindet,
wobei das Verfahren zur Herstellung die folgende Schritte umfasst:
E1) Platzieren eines anfänglichen Stapels (28) in einer Montageform (20), wobei der anfängliche Stapel (28) die Überlagerung der folgenden Elemente umfasst:
- mindestens eine erste trockene Verstärkung, die dazu bestimmt ist, der ersten Schicht (12) anzugehören und in die Zusammensetzung des ersten Verbundmaterials einzutreten,
- mindestens eine Photovoltaikzelle (16),
- mindestens eine zweite trockene Verstärkung, die dazu bestimmt ist, der zweiten Schicht (14) anzugehören und in die Zusammensetzung des zweiten Verbundmaterials einzutreten, und
- mindestens ein Verkapselungsmaterial (181, 182),
wobei der anfängliche Stapel (28) derart ist, dass sich die mindestens eine Photovoltaikzelle (16) zwischen der mindestens einen ersten trockenen Verstärkung und der mindestens einen zweiten trockenen Verstärkung befindet, und derart ist, dass sich das mindestens eine Verkapselungsmaterial (181, 182) zwischen der mindestens einen ersten trockenen Verstärkung und der mindestens einen zweiten trockenen Verstärkung befindet,
die Montageform (20), die eine Fähigkeit aufweist, zwischen einer Öffnungskonfiguration und einer Verschlusskonfiguration zu variieren und einen ersten starren Formteil (22), der einen ersten Abdruck (220) eingrenzt, der eine komplementäre Form zur ersten Schicht (12) aufweist, und einen zweiten starren Formteil (24) umfasst, der einen zweiten Abdruck (240) eingrenzt, der eine komplementäre Form zur zweiten Schicht (14) aufweist, der erste Formteil (22) und der zweite Formteil (24) ) derart sind, dass der erste Formteil (22) und der zweite Formteil (24) in der Verschlusskonfiguration der Montageform (20) um einen vorbestimmten Luftspalt (26) beabstandet sind, der vorzugsweise größer oder gleich der Dicke des anfänglichen Stapels (28) ist, und zwischen sich einen geschlossenen Hohlraum (30) eingrenzen, der geeignet ist, den anfänglichen Stapel (28) aufzunehmen,
E2) Transfergießen von Harz, bei dem ein Harz im flüssigen Zustand in einer Weise in den Hohlraum (30) injiziert wird, dass das Harz durch die mindestens eine erste trockene Verstärkung und durch die mindestens zweite trockene Verstärkung strömt, wobei die Temperatur des Harzes in Abhängigkeit vom wenigstens einen Verkapselungsmaterial (181, 182) angepasst ist, damit das mindestens eine Verkapselungsmaterial (181, 182) unter der Wirkung von durch das Harz übertragenen Kalorien mindestens teilweise verschmilzt und um das mindestens eine Verkapselungsmaterial (181, 182) in eine Verkapselungsanordnung (18) umzuwandeln, die einerseits an der mindestens einen Photovoltaikzelle (16) und andererseits an der ersten Schicht (12) und/oder der zweiten Schicht (14) haftet,
E3) Aushärten des in Schritt E2 injizierten Harzes, wobei der Schritt E3 durch eine geeignete Anpassung der im Hohlraum (30) herrschenden Temperatur in Abhängigkeit von der Art des Harzes durchgeführt wird, wobei die Kombination der mindestens einen ersten trockenen Verstärkung und des Harzes im ausgehärteten Zustand nach Abschluss des Schritts E3 das erste Verbundmaterial bildet und die Kombination der mindestens einen zweiten trockenen Verstärkung und des Harzes im ausgehärteten Zustand nach Abschluss des Schritts E3 das zweite Verbundmaterial bildet.

2. Verfahren zur Herstellung nach Anspruch 1, wobei der erste Abdruck (220) eine erste Form aufweist, sodass die erste Schicht (12) nach Abschluss des Schritts E3 entsprechend einer ersten linken Form ausgebildet ist, und der zweite Abdruck (240) eine zweite Form aufweist, sodass die zweite Schicht (14) nach Abschluss des Schritts E3 entsprechend einer zweiten linken Form räumlich ausgebildet ist.

3. Verfahren zur Herstellung nach einem der Ansprüche 1 oder 2, wobei der Schritt E2 nach dem Schritt E1 die folgenden Schritte umfasst:
- E21) Unterdruck, der auf den von der Montageform (20) in der Verschlusskonfiguration eingegrenzten Hohlraum (30) angelegt wird, bezogen auf den außerhalb des Hohlraums (30) herrschenden Druck,
- E22) Injizieren des Harzes in den Hohlraum (30) unter Druck mit einem Druck, der strikt über dem Druck liegt, der im Hohlraum (30) herrscht, wobei der Schritt E22 nach Schritt E21 durchgeführt wird.

4. Verfahren zur Herstellung nach Anspruch 3, wobei der Schritt E2 einen Schritt E20 zum Erwärmen des Harzes umfasst, der vor dem Umsetzen des Schritts E22 durchgeführt wird.

5. Verfahren zur Herstellung nach einem der Ansprüche 3 oder 4, wobei das Injizieren des Harzes in Schritt E22 in gelenkter Form in einer bevorzugten Richtung durchgeführt wird, in der das Harz vorzugsweise im Inneren des von der Montageform (20) eingegrenzten Hohlraums (30) zirkuliert, und wobei die Montageform (20) mindestens einen Abflussausgang (36) in Fluidverbindung mit einem Saugsystem umfasst, das es ermöglicht, einen Unterdruck in dem von der Montageform (20) eingegrenzten Hohlraum (30) aufzubauen.

6. Verfahren zur Herstellung nach Anspruch 5, wobei die Montageform (20) mindestens einen Versorgungseingang (32) in Fluidverbindung mit einem Versorgungssystem umfasst, das es ermöglicht, das Harz in Richtung des von der Montageform (20) eingegrenzten Hohlraums (30) zu injizieren.

7. Verfahren zur Herstellung nach Anspruch 6, wobei sich der mindestens eine Versorgungseingang (32) und der mindestens eine Abflussausgang (36) am Ende des Schritts E1 auf beiden Seiten des anfänglichen Stapels (28) in einer ersten Richtung (D1) befinden, die gemäß der bevorzugten Richtung ausgerichtet ist, und wobei die Montageform (20) mindestens ein erstes Drainagemedium (34) umfasst, in das der mindestens eine Versorgungseingang (32) mündet, wobei das erste Drainagemedium (34) für eine Drainage des Harzes in einer zweiten Richtung (D2), die quer zur ersten Richtung (D1) ausgerichtet ist, sorgt.

8. Verfahren zur Herstellung nach Anspruch 7, wobei die Montageform mindestens ein zweites Drainagemedium (38) umfasst, in das der mindestens eine Abflussausgang (36) mündet, wobei das zweite Drainagemedium (38) für eine Drainage des Harzes in einer zweiten Richtung (D2), die quer zur ersten Richtung (D1) ausgerichtet ist, sorgt.

9. Verfahren zur Herstellung nach einem der Ansprüche 3 bis 8, wobei in Schritt E21 der im Hohlraum (30) ausgebaute Druck zwischen 0,5.10⁵ Pa und 1.10⁵ Pa umfasst ist.

10. Verfahren zur Herstellung nach einem der Ansprüche 3 bis 9, wobei während des Schritts E22 das Injizieren des Harzes angesteuert wird, sodass der Druck, der in dem von der Montageform (20) eingegrenzten Hohlraum (30) herrscht, zwischen 2.10⁵ Pa und 50.10⁵ Pa umfasst ist.

11. Verfahren zur Herstellung nach einem der Ansprüche 1 bis 10, wobei das Harz ein thermoplastisches Harz ist, und wobei der Schritt E3 einen Schritt zum Absenken der Temperatur des aus Schritt E2 stammenden Stapels in Bezug auf die während des Schritts E2 vorliegenden Bedingungen umfasst.

12. Verfahren zur Herstellung nach einem der Ansprüche 1 bis 11, wobei das Harz ein duroplastisches Harz ist, und wobei der Schritt E3 einen Schritt zum Halten oder Erhöhen der Temperatur des aus Schritt E2 stammenden Stapels in Bezug auf die während des Schritts E2 vorliegenden Bedingungen umfasst.

13. Verfahren zur Herstellung nach einem der Ansprüche 1 bis 12, wobei der erste Formteil (22) und der zweite Formteil (24) der Montageform (20) während des gesamten Schritts E2 oder eines Teils davon, und während des gesamten Schritts E3 oder eines Teils davon auf den Stapel einen mechanischen Druck (F1) ausüben, wobei der mechanische Druck (F1) vorteilhafterweise zwischen 90,10⁵ Pa und 150,10⁵ Pa umfast ist, und insbesondere gleich 90,10⁵ Pa oder gleich 150,10⁵ Pa ist.

14. Verfahren zur Herstellung nach einem der Ansprüche 1 bis 13, umfassend einen Schritt E4 zum Öffnen der Montageform (20), wobei die Montageform (20) von der Verschlusskonfiguration in die Öffnungskonfiguration übergeht, wobei der Schritt E4 nach dem Schritt E3 umgesetzt wird.

15. Verfahren zur Herstellung nach einem der Ansprüche E1 bis 14, wobei in Schritt E1 das anfängliche Stapeln (28) weiter die Überlagerung einer Anschlussdose (7) umfasst, die dazu bestimmt ist, eine für den Betrieb des Photovoltaikmoduls (1) erforderliche Verkabelung aufzunehmen.

## Claims

1. A method for manufacturing a photovoltaic module (10), wherein the photovoltaic module (10) comprises:
- a first layer (12) formed from a first composite material, transparent, intended to form a front face of the photovoltaic module (10) and to receive a light flux,
- a second layer (14) formed from a second composite material and intended to form a rear face of the photovoltaic module (10),
- and at least one photovoltaic cell (16) located between the first layer (12) and the second layer (14),
the manufacturing method comprising the following steps:
E1) placing an initial stack (28) in an assembly mold (20), wherein the initial stack (28) comprises the superposition of the following elements:
- at least one first dry reinforcement intended to form part of the first layer (12) and to be incorporated into the first composite material,
- said at least one photovoltaic cell (16),
- at least one second dry reinforcement intended to form part of the second layer (14) and to be incorporated into the second composite material, and
- at least one encapsulating material (181, 182),
the initial stack (28) being such that said at least one photovoltaic cell (16) is located between the at least one first dry reinforcement and the at least one second dry reinforcement, and such that the at least one encapsulating material (181, 182) is located between the at least one first dry reinforcement and the at least one second dry reinforcement,
the assembly mold (20) being capable of varying between an open configuration and a closed configuration and comprising a rigid first mold part (22) defining a first mold cavity (220) having a shape complementary to the shape of the first layer (12) and a rigid second mold part (24) defining a second mold cavity (240) having a shape complementary to the shape of the second layer (14), the first mold part (22) and the second mold part (24) being such that, in the closed configuration of the assembly mold (20), the first mold part (22) and the second mold part (24) are spaced apart by a predetermined gap (26) preferably greater than or equal to the thickness of the initial stack (28), and define between them a closed cavity (30) capable of receiving the initial stack (28),
E2) resin transfer molding, in which a liquid resin is injected into the cavity (30) in such a manner that the resin passes through the at least one first dry reinforcement and through the at least one second dry reinforcement, the temperature of the resin being adapted according to the at least one encapsulating material (181, 182) so that the at least one encapsulating material (181, 182) undergoes at least partial melting under the effect of heat transferred by the resin and so as to convert the at least one encapsulating material (181, 182) into an encapsulating assembly (18) adhering, on the one hand, to the at least one photovoltaic cell (16) and, on the other hand, to the first layer (12) and/or the second layer (14),
E3) curing the resin injected in step E2, step E3 being carried out by suitably adjusting the temperature prevailing in the cavity (30), according to the nature of the resin, the combination of the at least one first dry reinforcement and the resin in its cured state at the end of step E3 constituting said first composite material, and the combination of the at least one second dry reinforcement and the resin in its cured state at the end of step E3 constituting said second composite material.

2. The manufacturing method according to claim 1, wherein the first mold cavity (220) has a first shape such that the first layer (12) is shaped into a first non-developable shape at the end of step E3, and the second mold cavity (240) has a second shape such that the second layer (14) is spatially shaped into a second non-developable shape at the end of step E3.

3. The manufacturing method according to either claim 1 or claim 2, wherein step E2 comprises, after step E1, the following steps:
- E21) applying a vacuum to the cavity (30) defined by the assembly mold (20) in the closed configuration, relative to the pressure prevailing outside the cavity (30),
- E22) injecting the resin into the cavity (30) under pressure at a pressure strictly greater than the pressure prevailing in the cavity (30), step E22 being carried out after step E21.

4. The manufacturing method according to claim 3, wherein step E2 comprises a step E20 of heating the resin, carried out before step E22 is implemented.

5. The manufacturing method according to any one of claims 3 or 4, wherein, in step E22, the resin is injected in a directed manner along a preferred direction in which the resin preferentially flows inside the cavity (30) defined by the assembly mold (20), and wherein the assembly mold (20) comprises at least one evacuation outlet (36) in fluid communication with a suction system allowing a vacuum to be established in the cavity (30) defined by the assembly mold (20).

6. The manufacturing method according to claim 5, wherein the assembly mold (20) comprises at least one feed inlet (32) in fluid communication with a feed system allowing the resin to be injected toward the cavity (30) defined by the assembly mold (20).

7. The manufacturing method according to claim 6, wherein, at the end of step E1, the at least one feed inlet (32) and the at least one evacuation outlet (36) are located on either side of the initial stack (28) along a first direction (D1) oriented in the preferred direction, and wherein the assembly mold (20) comprises at least one first drainage medium (34) into which the at least one feed inlet (32) opens, said first drainage medium (34) ensuring a drainage of the resin along a second direction (D2) oriented transversely to the first direction (D1).

8. The manufacturing method according to claim 7, wherein the assembly mold comprises at least one second drainage medium (38) into which the at least one evacuation outlet (36) opens, said second drainage medium (38) ensuring a drainage of the resin along a second direction (D2) oriented transversely to the first direction (D1).

9. The manufacturing method according to any one of claims 3 to 8, wherein, in step E21, the pressure established in the cavity (30) is comprised between 0.5.10⁵ Pa and 1.10⁵ Pa.

10. The manufacturing method according to any one of claims 3 to 9, wherein, during step E22, the resin injection is controlled such that the pressure prevailing in the cavity (30) defined by the assembly mold (20) is comprised between 2.10⁵ Pa and 50.10⁵ Pa.

11. The manufacturing method according to any one of claims 1 to 10, wherein the resin is a thermoplastic resin, and wherein step E3 comprises a step of lowering the temperature of the stack resulting from step E2 relative to the conditions prevailing during step E2.

12. The manufacturing method according to any one of claims 1 to 11, wherein the resin is a thermosetting resin, and wherein step E3 comprises a step of maintaining or increasing the temperature of the stack resulting from step E2 relative to the conditions prevailing during step E2.

13. The manufacturing method according to any one of claims 1 to 12, wherein the first mold part (22) and the second mold part (24) of the assembly mold (20) exert a mechanical pressure (F1) on the stack during all or part of step E2 and during all or part of step E3, wherein the mechanical pressure (F1) is advantageously between 90.10⁵ Pa and 150.10⁵ Pa, and more particularly equal to 90.10⁵ Pa or equal to 150.10⁵ Pa.

14. The manufacturing method according to any one of claims 1 to 13, comprising a step E4 of opening the assembly mold (20), in which the assembly mold (20) transitions from the closed configuration to the open configuration, step E4 being carried out after step E3.

15. The manufacturing method according to any one of claims 1 to 14, wherein, during step E1, the initial stack (28) further comprises the superposition of a junction box (7) intended to receive wiring required for operation of the photovoltaic module (1).
